# EUROPEAN PATENT APPLICATION

(11) **EP 4 852 676 A1**
(43) Date of publication of application: **09.12.2026**
(21) Application number: 24943786.4
(22) Date of filing: 25.06.2024
(51) Int. Cl.: H10K 59/12, H10K 59/80

(54) **DISPLAY SUBSTRATE AND MANUFACTURING METHOD THEREFOR, AND DISPLAY APPARATUS**

(71) Applicant: Boe Technology Group Co., Ltd., Beijing 100015 (CN); Beijing BOE Technology Development Co., Ltd., Daxing District Beijing 100176 (CN)
(72) Inventor: LI, Liuqing, Beijing 100176 (CN); DONG, Shuilang, Beijing 100176 (CN); CAO, Zhanfeng, Beijing 100176 (CN); LU, Xinhong, Beijing 100176 (CN); YANG, Shaopeng, Beijing 100176 (CN); LI, Guoteng, Beijing 100176 (CN); LI, Chun, Beijing 100176 (CN)
(74) Representative: Potter Clarkson
(86) International application number: PCT/CN2024/101329
(87) International publication number: WO 2026/000177

(57) **Abstract**

A display substrate is provided, including: a base substrate; a driving circuit layer; a light-emitting device layer including a plurality of light-emitting devices, where the light-emitting device includes a first electrode, a light-emitting functional portion and a second electrode, the light-emitting device layer includes at least one light-emitting unit, the light-emitting unit includes at least two light-emitting devices and a connecting electrode sequentially connected in series; and a conductive layer including a conductive portion, where the conductive portion includes at least two spaced first conductive sub-portions; in the light-emitting unit, for two adjacent and electrically connected light-emitting devices, the second electrode of one light-emitting device is electrically connected to the first electrode of the other light-emitting device through the first conductive sub-portion, and for the connecting electrode and the light-emitting device electrically connected to the connecting electrode, the connecting electrode is electrically connected to the second electrode of the light-emitting device through the first conductive sub-portion. The display substrate further includes a partition portion, at least one partition portion is provided between two adjacent first conductive sub-portions.

## Description

### TECHNICAL FIELD

The present disclosure relates to a field of display technology, and in particular to a display substrate, a method of manufacturing a display substrate, and a display apparatus.

### BACKGROUND

Micro light-emitting diode (Micro LED) is a light-emitting diode with a micrometer-scale size. Due to the small size, Micro LED may serve as a pixel of a display panel. A display substrate fabricated using Micro LEDs may be referred to as a Micro LED display substrate. In a Micro LED product, Micro LED technology entails reducing a size of existing LED to below 100 µm, which is approximately 1% of the size of existing LED, and then transferring the micrometer-scale Micro LEDs to a driver substrate through mass transfer technology, thereby forming various sizes of Micro LED displays. How to optimize relevant structures of a display product to improve display resolution is one of important research topics for developers.

The above information disclosed in this section is merely for the understanding of the inventive concept of the present disclosure. Therefore, the above information may contain information that does not constitute the related art.

### SUMMARY

In an aspect, a display substrate is provided, including: a base substrate; a driving circuit layer on the base substrate; a light-emitting device layer on a side of the driving circuit layer away from the base substrate, where the light-emitting device layer includes a plurality of light-emitting devices arranged in an array along a first direction and a second direction, the light-emitting device includes a first electrode on the driving circuit layer, a light-emitting functional portion on a side of the first electrode away from the base substrate and a second electrode on a side of the light-emitting functional portion away from the base substrate, the light-emitting device layer includes at least one light-emitting unit, the light-emitting unit includes at least two light-emitting devices and a connecting electrode sequentially connected in series; and a conductive layer on a side of the plurality of light-emitting devices away from the base substrate, where the conductive layer includes at least one conductive portion, an orthographic projection of the conductive portion on the base substrate overlaps at least partially with an orthographic projection of the light-emitting unit on the base substrate, and the conductive portion includes at least two first conductive sub-portions arranged at intervals; where in the light-emitting unit, for two adjacent and electrically connected light-emitting devices, the second electrode of one light-emitting device is electrically connected to the first electrode of the other light-emitting device through the first conductive sub-portion, and for the connecting electrode and the light-emitting device electrically connected to the connecting electrode, the connecting electrode is electrically connected to the second electrode of the light-emitting device through the first conductive sub-portion; and where the display substrate further includes a partition portion, and at least one partition portion is provided between two adjacent first conductive sub-portions.

According to some exemplary embodiments, the partition portion includes a first partition portion, and at least one first partition portion is provided between two adjacent first conductive sub-portions in the conductive portion; and/or the partition portion includes a second partition portion, and at least one second partition portion is provided between two adjacent conductive portions.

According to some exemplary embodiments, for two adjacent light-emitting devices in the light-emitting unit, the first electrode of one light-emitting device has an extension portion extending beyond an edge of the light-emitting functional portion, and the extension portion is electrically connected to the second electrode of the other light-emitting device through the first conductive sub-portion.

According to some exemplary embodiments, at least part of the first partition portion is located on a side of the extension portion away from the base substrate, and a size of the first partition portion along an extension direction of the first partition portion is greater than or equal to a size of the extension portion along the extension direction of the first partition portion.

According to some exemplary embodiments, the partition portion has a first surface away from the base substrate and a second surface facing the base substrate, and an orthographic projection of the second surface on the base substrate falls within an orthographic projection of the first surface on the base substrate.

According to some exemplary embodiments, the display substrate further includes a cover layer between the plurality of light-emitting devices and the conductive layer, where the cover layer includes a plurality of cover portions respectively cover at least parts of surfaces of the plurality of light-emitting devices; where the cover portion includes a first opening exposing at least part of the second electrode of the light-emitting device, and the first conductive sub-portion is electrically connected to the second electrode of the light-emitting device through the first opening; and where the partition portion is located in the cover layer.

According to some exemplary embodiments, one partition portion is provided between two adjacent first conductive sub-portions, the partition portion is connected to an adjacent cover portion to form an integral structure and is spaced apart from another adjacent cover portion, and the two adjacent first conductive sub-portions are disconnected from each other at the partition portion.

According to some exemplary embodiments, two spaced partition portions are provided between two adjacent first conductive sub-portions, and the two adjacent first conductive sub-portions are disconnected from each other at a spacing position between the two partition portions; one of the partition portions is connected to an adjacent cover portion to form an integral structure, and the other partition portion is spaced apart from an adjacent cover portion; and/or one of the partition portions is connected to an adjacent cover portion to form an integral structure, and the other partition portion is connected to an adjacent cover portion to form an integral structure; and/or one of the partition portions is spaced apart from an adjacent cover portion, and the other partition portion is spaced apart from an adjacent cover portion.

According to some exemplary embodiments, the conductive portion further includes a second conductive sub-portion located between the two spaced partition portions, and the second conductive sub-portion is disconnected from the two adjacent first conductive sub-portions at the two partition portions.

According to some exemplary embodiments, one partition portion is provided between two adjacent first conductive sub-portions, the partition portion is spaced apart from two cover portions adjacent to the partition, and the two adjacent first conductive sub-portions are respectively located on both sides of the partition portion.

According to some exemplary embodiments, the cover layer includes a passivation layer, the passivation layer includes a first passivation sub-layer on a side of the plurality of light-emitting devices away from the base substrate and a second passivation sub-layer on a side of the first passivation sub-layer away from the base substrate, the partition portion includes a first partition sub-portion and a second partition sub-portion on a side of the first partition sub-portion away from the base substrate, the first partition sub-portion is located in the first passivation sub-layer, the second partition sub-portion is located in the second passivation sub-layer, and an orthographic projection of the first partition sub-portion on the base substrate falls within an orthographic projection of the second partition sub-portion on the base substrate.

According to some exemplary embodiments, the cover layer includes an organic protective layer, the partition portion is located in the organic protective layer, and a cross-section of the partition portion along a direction perpendicular to the base substrate is in a shape of an inverted trapezoid.

According to some exemplary embodiments, the connecting electrode is located on a side of the driving circuit layer away from the base substrate, and the connecting electrode is spaced apart from an adjacent light-emitting device.

According to some exemplary embodiments, the connecting electrode and the first electrode are located in a same layer.

According to some exemplary embodiments, the connecting electrode is located on a side of the conductive layer away from the base substrate, the connecting electrode is electrically connected to the first conductive sub-portion, and an orthographic projection of the connecting electrode on the base substrate overlaps at least partially with an orthographic projection of the light-emitting functional portion on the base substrate.

According to some exemplary embodiments, the display substrate further includes at least one auxiliary electrode electrically connected to the connecting electrode, and an orthographic projection of the auxiliary electrode on the base substrate does not overlap with the orthographic projection of the light-emitting functional portion on the base substrate.

According to some exemplary embodiments, the at least one light-emitting unit includes a first light-emitting unit, a second light-emitting unit and a third light-emitting unit, and the light-emitting device is configured to emit third-color light; the display substrate further includes a color conversion layer on a side of the conductive layer away from the base substrate or on a side of the base substrate away from the light-emitting device layer; and the color conversion layer includes a first color conversion portion and a second color conversion portion, an orthographic projection of the first color conversion portion on the base substrate overlaps at least partially with an orthographic projection of the first light-emitting unit on the base substrate, the first color conversion portion is configured to convert the third-color light into first-color light, an orthographic projection of the second color conversion portion on the base substrate overlaps at least partially with an orthographic projection of the second light-emitting unit on the base substrate, and the second color conversion portion is configured to convert the third-color light into second-color light.

According to some exemplary embodiments, the cover layer includes a reflective layer, the reflective layer includes a plurality of reflective portions covering at least part of sidewalls of the plurality of light-emitting devices, the light-emitting device is configured to emit third-color light, and the reflective portion is configured to reflect the third-color light and transmit first-color light and second-color light.

According to some exemplary embodiments, the partition portion is located in the reflective layer.

According to some exemplary embodiments, the reflective layer includes at least two first reflective sub-layers and at least two second reflective sub-layers alternately arranged along a direction away from the base substrate, and a refractive index of the first reflective sub-layer is less than a refractive index of the second reflective sub-layer; the partition portion includes at least two first partition sub-portions and at least two second partition sub-portions, the at least two first partition sub-portions are respectively located in the at least two first reflective sub-layers, and the at least two second partition sub-portions are respectively located in the two second reflective sub-layers; and for a first partition sub-portion and a second partition sub-portion adjacent to each other, an orthographic projection of the first partition sub-portion on the base substrate falls within an orthographic projection of the second partition sub-portion on the base substrate, or the orthographic projection of the second partition sub-portion on the base substrate falls within the orthographic projection of the first partition sub-portion on the base substrate.

According to some exemplary embodiments, the display substrate further includes a planarization layer on a side of the conductive layer away from the reflective layer, where the planarization layer has a second opening that exposes at least part of the first conductive sub-portion electrically connected to the second electrode of the light-emitting device; and where the connecting electrode is located on a side of the planarization layer away from the base substrate, and the connecting electrode is electrically connected to the first conductive sub-portion through the second opening.

According to some exemplary embodiments, the at least one light-emitting unit includes a first light-emitting unit, a second light-emitting unit and a third light-emitting unit, and the light-emitting device is configured to emit third-color light; the display substrate further includes a color conversion layer on a side of the base substrate away from the light-emitting device layer; and the color conversion layer includes a first color conversion portion, a second color conversion portion and a light-transmitting portion, an orthographic projection of the first color conversion portion on the base substrate overlaps at least partially with an orthographic projection of the first light-emitting unit on the base substrate, the first color conversion portion is configured to convert the third-color light into first-color light, an orthographic projection of the second color conversion portion on the base substrate overlaps at least partially with an orthographic projection of the second light-emitting unit on the base substrate, the second color conversion portion is configured to convert the third-color light into second-color light, an orthographic projection of the light-transmitting portion on the base substrate overlaps at least partially with an orthographic projection of the third light-emitting unit on the base substrate, and the light-transmitting portion is configured to transmit the third-color light.

According to some exemplary embodiments, a plurality of grooves are provided on the side of the base substrate away from the light-emitting device layer, the plurality of grooves include a first groove, and at least part of the first color conversion portion is embedded in the first groove; and/or the plurality of grooves include a second groove, and at least part of the second color conversion portion is embedded in the second groove; and/or the plurality of grooves include a third groove, and at least part of the light-transmitting portion is embedded in the third groove.

According to some exemplary embodiments, at least part of the grooves is provided with a metal reflective portion, the metal reflective portion is located between the base substrate and the color conversion layer, and the metal reflective portion covers at least part of sidewalls of the grooves.

According to some exemplary embodiments, the display substrate further includes a semi-transparent semi-reflective layer on a side of the color conversion layer away from the base substrate, and the semi-transparent semi-reflective layer is configured to transmit the first-color light and the second-color light and reflect the third-color light; an orthographic projection of the semi-transparent semi-reflective layer on the base substrate overlaps at least partially with the orthographic projection of the first color conversion portion on the base substrate; and/or the orthographic projection of the semi-transparent semi-reflective layer on the base substrate overlaps at least partially with the orthographic projection of the second color conversion portion on the base substrate.

According to some exemplary embodiments, in at least one light-emitting unit, the at least two light-emitting devices are arranged along the first direction, and the first partition portion extends along the second direction; and/or in at least one light-emitting unit, the at least two light-emitting devices are arranged along the second direction, and the first partition portion extends along the first direction.

According to some exemplary embodiments, in at least one light-emitting unit, at least two light-emitting devices are arranged along the first direction and at least two light-emitting devices are arranged along the second direction; between two light-emitting devices adjacent in the first direction, the first partition portion extends along the second direction; and/or between two light-emitting devices adjacent in the second direction, the first partition portion extends along the first direction.

According to some exemplary embodiments, an orthographic projection of the light-emitting device on the base substrate is in a shape a circle, an ellipse, a rectangle, or a rounded rectangle.

In another aspect, a method of manufacturing a display substrate is provided, including: forming a driving circuit layer on a base substrate; forming a light-emitting device layer on a side of the driving circuit layer away from the base substrate, where the light-emitting device layer includes a plurality of light-emitting devices arranged in an array along a first direction and a second direction, the light-emitting device includes a first electrode on the driving circuit layer, a light-emitting functional portion on a side of the first electrode away from the base substrate and a second electrode on a side of the light-emitting functional portion away from the base substrate, the light-emitting device layer includes at least one light-emitting unit, and the light-emitting unit includes at least two light-emitting devices and a connecting electrode; forming a partition portion on a side of the driving circuit layer away from the base substrate; and forming a conductive layer on a side of the light-emitting device layer and the partition portion away from the base substrate, where the conductive layer includes at least one conductive portion, an orthographic projection of the conductive portion on the base substrate overlaps at least partially with an orthographic projection of the light-emitting unit on the base substrate, the conductive portion includes at least two first conductive sub-portions arranged at intervals, at least one partition portion is provided between two adjacent first conductive sub-portions, where in a light-emitting unit, for two adjacent light-emitting devices, the second electrode of one light-emitting device is electrically connected to the first electrode of the other light-emitting device through the first conductive sub-portion, and for the connecting electrode and the light-emitting device adjacent to the connecting electrode, the connecting electrode is electrically connected to the second electrode of the light-emitting device through the first conductive sub-portion.

In another aspect, a display apparatus is provided, including the display substrate as described above.

### BRIEF DESCRIPTION OF THE DRAWINGS

By describing in detail exemplary embodiments of the present disclosure with reference to the accompanying drawings, features and advantages of the present disclosure will become clearer.
FIG. 1 schematically shows a schematic plan view of a display substrate according to some embodiments of the present disclosure.
FIG. 2A schematically shows an enlarged view of the display substrate in region A1 of FIG. 1 according to some embodiments of the present disclosure.
FIG. 2B schematically shows a cross-sectional view taken along line BB' in FIG. 2A.
FIG. 2C schematically shows an enlarged view of the display substrate in region A1 of FIG. 1 according to other embodiments of the present disclosure.
FIG. 3A schematically shows an enlarged view of the display substrate in region A1 of FIG. 1 according to some embodiments of the present disclosure.
FIG. 3B schematically shows a cross-sectional view taken along line CC' in FIG. 3A.
FIG. 4 schematically shows a cross-sectional view of the display substrate taken along line NN' in FIG. 1 according to some embodiments of the present disclosure.
FIG. 5A schematically shows an enlarged view of the display substrate in region A1 of FIG. 1 according to some embodiments of the present disclosure.
FIG. 5B schematically shows a cross-sectional view taken along line DD' in FIG. 5A.
FIG. 6A schematically shows an enlarged view of the display substrate in region A1 of FIG. 1 according to some embodiments of the present disclosure.
FIG. 6B schematically shows a cross-sectional view taken along line EE' in FIG. 6A.
FIG. 7 schematically shows a cross-sectional view of the display substrate taken along line MM' in FIG. 1 according to some embodiments of the present disclosure.
FIG. 8A schematically shows a cross-sectional view of the display substrate taken along line MM' in FIG. 1 according to some embodiments of the present disclosure.
FIG. 8B shows a cross-sectional view of alternately arranged silicon oxide films and niobium oxide films after etching at a first opening, characterized by a scanning electron microscope.
FIG. 8C shows a cross-sectional view of alternately arranged silicon oxide films and niobium oxide films after etching at a second opening, characterized by a scanning electron microscope.
FIG. 9 schematically shows a cross-sectional view of the display substrate taken along line MM' in FIG. 1 according to some embodiments of the present disclosure.
FIG. 10A schematically shows an enlarged view of the display substrate in region A1 of FIG. 1 according to some embodiments of the present disclosure.
FIG. 10B schematically shows an enlarged view of the display substrate in region A2 of FIG. 1 according to some embodiments of the present disclosure.
FIG. 10C schematically shows an enlarged view of the display substrate in region A3 of FIG. 1 according to some embodiments of the present disclosure.
FIG. 10D schematically shows a cross-sectional view taken along line FF' in FIG. 10A.
FIG. 11 schematically shows a flowchart of a method of manufacturing a display substrate according to embodiments of the present disclosure.
FIG. 12A to FIG. 12I schematically show process diagrams of forming the display substrate according to some embodiments of the present disclosure.
FIG. 13A to FIG. 13K schematically show process diagrams of forming the display substrate according to some embodiments of the present disclosure.

### DETAILED DESCRIPTION OF EMBODIMENTS

In order to make objectives, technical solutions and advantages of embodiments of the present disclosure clearer, technical solutions of embodiments of the present disclosure will be clearly and completely described below with reference to the accompanying drawings. Obviously, the described embodiments are just some embodiments rather than all embodiments of the present disclosure. Based on the described embodiments of the present disclosure, all additional embodiments obtained by those ordinary skilled in the art without carrying out inventive effort fall within the scope of protection of the present disclosure.

It should be noted that in the accompanying drawings, for clarity and/or description purposes, a size and relative size of an element may be enlarged. Accordingly, the size and relative size of each element need not to be limited to those shown in the figures. In the specification and the accompanying drawings, the same or similar reference numerals represent the same or similar components.

When an element is described as being "on", "connected to" or "coupled to" another element, the element may be directly on the another element, directly connected to the another element, or directly coupled to the another element, or an intermediate element may be provided. However, when an element is described as being "directly on", "directly connected to" or "directly coupled to" another element, no intermediate element is provided. Other terms and/or expressions used to describe a relationship between elements, such as "between" and "directly between", "adjacent to" and "directly adjacent to", "on" and "directly on", and so on, should be interpreted in a similar manner. Moreover, the term "connection" may refer to a physical connection, an electrical connection, a communicative connection, and/or a fluid connection. In addition, X-axis, Y-axis and Z-axis are not limited to three axes of a rectangular coordinate system, and may be interpreted in a broader meaning. For example, the X-axis, the Y-axis and the Z-axis may be perpendicular to each other, or may represent different directions that are not perpendicular to each other. For objectives of the present disclosure, "at least one selected from X, Y or Z" and "at least one selected from a group consisting of X, Y and Z" may be interpreted as only X, only Y, only Z, or any combination of two or more of X, Y and Z, such as XYZ, XY, YZ and ZZ. As used herein, the term "and/or" includes any and all combinations of one or more of the listed related items.

It should be noted that although the terms "first", "second", and so on may be used herein to describe various components, members, elements, regions, layers and/or portions, these components, members, elements, regions, layers and/or portions should not be limited by these terms. Rather, these terms are used to distinguish one component, member, element, region, layer and/or portion from another one. Thus, for example, a first component, a first member, a first element, a first region, a first layer and/or a first portion discussed below may be referred to as a second component, a second member, a second element, a second region, a second layer and/or a second portion without departing from teachings of the present disclosure.

For ease of description, spatial relationship terms, such as "upper", "lower", "left", "right", may be used herein to describe a relationship between an element or feature and another element or feature as shown in the figures. It should be understood that the spatial relationship terms are intended to cover other different orientations of a device in use or operation in addition to the orientation described in the figures. For example, if a device in the figures is turned upside down, an element or feature described as "below" or "under" another element or feature will be oriented "above" or "on" the another element or feature.

Here, the terms "substantially", "about", "approximately", "roughly" and other similar terms are used as terms of approximation rather than terms of degree, and they are intended to explain an inherent deviation of a measured or calculated value that will be recognized by those ordinary skilled in the art. Taking into account a process fluctuation, a measurement problem, an error related to a measurement of a specific quantity (that is, a limitation of a measurement system) and other factors, the terms "about" or "approximately" used herein includes a stated value and means that a specific value determined by those ordinary skilled in the art is within an acceptable range of deviation. For example, "about" may mean being within one or more standard deviations, or within ±30%, ±20%, ±10% or ±5% of the stated value.

It should be noted that the expression "the same layer" herein refers to a layer structure that is formed by forming, using a same film forming process, a film layer used to form a specific pattern, and then patterning, using one-time patterning process, the film layer with a same mask. Depending on different specific patterns, the one-time patterning process may include a plurality of exposure, development or etching processes, and the specific pattern in the formed layer structure may be continuous or discontinuous. That is, a plurality of elements, components, structures and/or portions located in the "same layer" are made of the same material and formed by the same patterning process. Generally, a plurality of elements, components, structures and/or portions located in the "same layer" have substantially the same thickness.

Those skilled in the art should understand that, unless otherwise specified, the expression "height" or "thickness" herein refers to a size in a direction perpendicular to a surface of each film layer provided on the display substrate, that is, a size in a light emitting direction of the display substrate, or called a size in a normal direction of the display apparatus.

Herein, the term "transistor" may refer to a triode, a thin-film transistor, a field-effect transistor, or other devices with the same characteristics. In embodiments of the present disclosure, to distinguish two electrodes of the transistor other than a control electrode, one of the two electrodes is referred to as a first electrode, and the other electrode is referred to as a second electrode. In practical operation, when the transistor is a thin-film transistor or a field-effect transistor, the first electrode may be a drain electrode, and the second electrode may be a source electrode; or the first electrode may be a source electrode, and the second electrode may be a drain electrode.

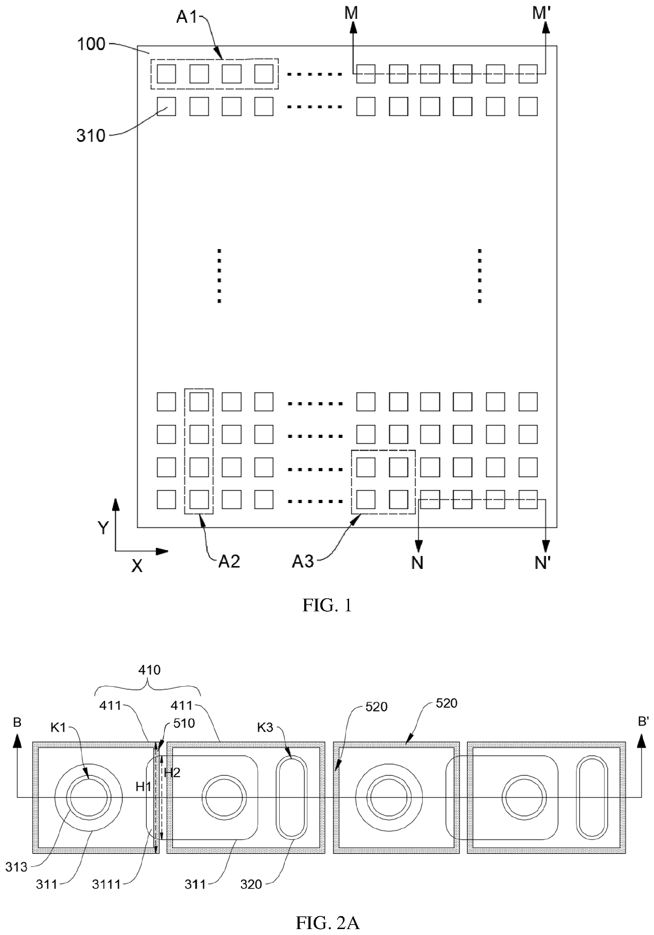

FIG. 1 schematically shows a schematic plan view of a display substrate according to some embodiments of the present disclosure.

FIG. 2A schematically shows an enlarged view of the display substrate in region A1 of FIG. 1 according to some embodiments of the present disclosure, in which FIG. 2A schematically shows a first electrode of a light-emitting device, a second electrode of the light-emitting device, a connecting electrode, a conductive layer, a first opening and a third opening of a cover layer, and a partition portion.

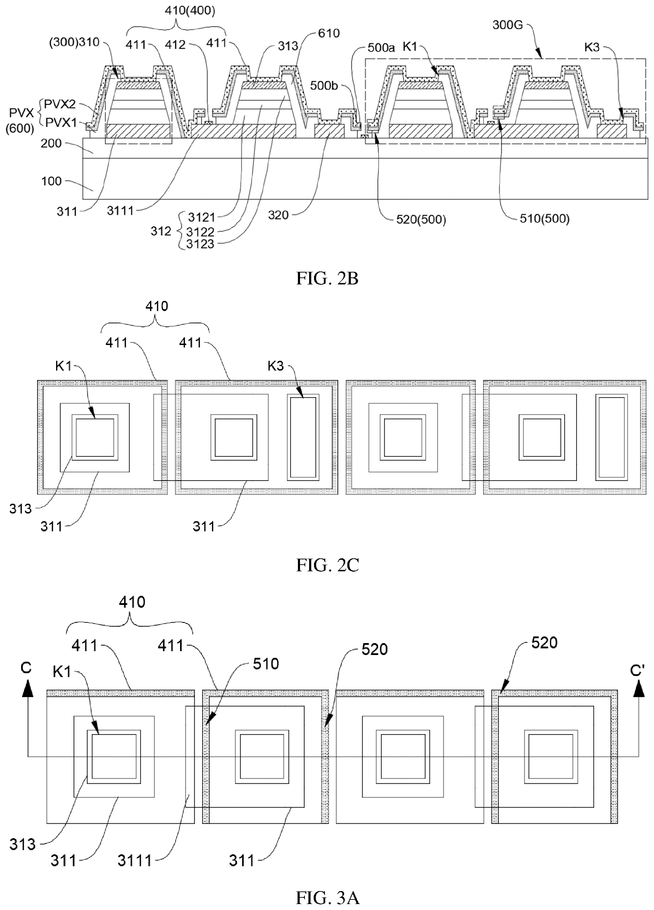

FIG. 2B schematically shows a cross-sectional view taken along line BB' in FIG. 2A.

Referring to FIG. 1, FIG. 2A and FIG. 2B, the display substrate includes a base substrate 100, a driving circuit layer 200, a light-emitting device layer 300 and a conductive layer 400. The driving circuit layer 200 is located on the base substrate 100. The light-emitting device layer 300 is located on a side of the driving circuit layer 200 away from the base substrate 100 and is electrically connected to the driving circuit layer 200. The conductive layer 400 is located on a side of the light-emitting device layer 300 away from the base substrate 100 and is electrically connected to the light-emitting device layer 300.

The light-emitting device layer 300 includes a plurality of light-emitting devices 310 arranged in an array along a first direction X and a second direction Y. The light-emitting device 310 includes a first electrode 311 on the driving circuit layer 200, a light-emitting functional portion 312 on a side of the first electrode 311 away from the base substrate 100, and a second electrode 313 on a side of the light-emitting functional portion 312 away from the base substrate 100. The light-emitting device layer 300 includes at least one light-emitting unit 300G, and the light-emitting unit 300G includes at least two light-emitting devices 310 and a connecting electrode 320 that are sequentially connected in series.

The conductive layer 400 includes at least one conductive portion 410. An orthographic projection of the conductive portion 410 on the base substrate 100 overlaps at least partially with an orthographic projection of the light-emitting unit 300G on the base substrate 100. The conductive portion 410 is electrically connected to the light-emitting unit 300G to achieve series connection of the light-emitting devices 310 and the connecting electrode 320 in the light-emitting unit 300G.

The conductive portion 410 includes at least two first conductive sub-portions 411 arranged at intervals. In the light-emitting unit 300G, for two adjacent and electrically connected light-emitting devices 310, the second electrode 313 of one light-emitting device 310 is electrically connected to the first electrode 311 of the other light-emitting device 310 through the first conductive sub-portion 411; and for the connecting electrode 320 and the light-emitting device 310 electrically connected to the connecting electrode 320, the connecting electrode 320 is electrically connected to the second electrode 313 of the light-emitting device 310 through the first conductive sub-portion 411. That is, the light-emitting devices 310 and the connecting electrode 320 are sequentially connected in series through bridging of the first conductive portions 410.

In embodiments of the present disclosure, the display substrate further includes a partition portion 500. At least one partition portion 500 is provided between two adjacent first conductive sub-portions 411. By providing the partition portions 500 at predetermined positions, the formed conductive layer 400 may be partitioned by the partition portions 500 into a plurality of first conductive sub-portions 411 arranged at intervals. In this way, a conductive layer 400 with a predetermined pattern may be formed through a thin-film deposition process without a patterning process, thereby saving manufacturing processes and reducing the manufacturing cost of the display substrate. Moreover, compared with a plurality of first conductive sub-portions 411 formed by a patterning process, a distance between two adjacent first conductive sub-portions 411 partitioned by the partition portion 500 may be significantly reduced, that is, a distance between adjacent light-emitting devices 310 may be reduced, thereby improving the resolution of the display substrate.

For example, the light-emitting device 310 may be a micro light-emitting diode (Micro LED). The light-emitting functional portion 312 includes a first semiconductor portion 3121 on the first electrode 311, a light-emitting portion 3122 on a side of the first semiconductor portion 3121 away from the first electrode 311, and a second semiconductor portion 3123 on a side of the light-emitting portion 3122 away from the base substrate 100.

For example, one of the first semiconductor portion 3121 and the second semiconductor portion 3123 is an N-type semiconductor portion, and the other is a P-type semiconductor portion. The material of the N-type semiconductor portion may include N-type gallium nitride, and the material of the P-type semiconductor portion may include P-type gallium nitride.

For example, the light-emitting portion 3122 may include a multiple quantum well (MQW) structure, which may be a periodic structure of alternately arranged gallium nitride (GaN) and indium gallium nitride (InGaN), but is not limited thereto.

According to some exemplary embodiments, referring to FIG. 2A andFIG. 2B, the partition portion 500 includes a first partition portion 510. At least one first partition portion 510 is provided between two adjacent first conductive sub-portions 411 in a conductive portion 410. By providing the first partition portion 510 at a spacing position between adjacent first conductive sub-portions 411 in the conductive portion 410, the formed conductive portion 410 is partitioned by the first partition portion 510 into at least two first conductive sub-portions 411.

According to some exemplary embodiments, referring to FIG. 2A and FIG. 2B, the partition portion 500 includes a second partition portion 520. At least one second partition portion 520 is provided between two adjacent conductive portions 410. By providing the second partition portion 520 at a spacing position between adjacent conductive portions 410, the formed conductive layer 400 is partitioned by the second partition portion 520 into at least two conductive portions 410.

According to some exemplary embodiments, referring to FIG. 2A andFIG. 2B in two adjacent and electrically connected light-emitting devices 310 in the light-emitting unit 300G, the first electrode 311 of one light-emitting device 310 has an extension portion 3111 extending beyond an edge of the light-emitting functional portion 312, an orthographic projection of the extension portion 3111 on the base substrate 100 does not overlap with an orthographic projection of the light-emitting functional portion 312 of the light-emitting device 310 on the base substrate 100, and the extension portion 3111 is electrically connected to the second electrode 313 of the other light-emitting device 310 through the first conductive sub-portion 411, thereby achieving series connection of the two adjacent light-emitting devices 310.

According to some exemplary embodiments, referring to FIG. 2A and FIG. 2B, at least part of the first partition portion 510 is located on a side of the extension portion 3111 away from the base substrate 100, and a size H1 of the first partition portion 510 along the extension direction of the first partition portion 510 is greater than or equal to a size H2 of the extension portion 3111 along the extension direction of the first partition portion 510, so as to ensure that the two adjacent first conductive sub-portions 411 may be completely partitioned by the first partition portion 510.

It should be noted that the extension direction of the first partition portion 510 may be understood as an extension direction of an edge of the conductive portion 410 formed by partitioning of the first partition portion 510.

According to some exemplary embodiments, referring toFIG. 2B, the partition portion 500 has a first surface away from the base substrate 100 and a second surface facing the base substrate 100, and an orthographic projection of the second surface on the base substrate 100 falls within an orthographic projection of the first surface on the base substrate 100. That is, a sidewall of the partition portion 500 has an undercut structure, which may achieve a good partitioning effect, so that the conductive layer 400 may be disconnected at the sidewall of the partition portion 500.

According to some exemplary embodiments, referring to FIG. 2A and FIG. 2B the display substrate further includes a cover layer 600 located between the plurality of light-emitting devices 310 and the conductive layer 400. The cover layer 600 includes a plurality of cover portions 610 arranged at intervals, and the plurality of cover portions 610 respectively cover at least parts of surfaces of the plurality of light-emitting devices 310. The cover portion 610 has a first opening K1 that exposes at least part of the second electrode 313 of the light-emitting device 310, and the first conductive sub-portion 411 is electrically connected to the second electrode 313 of the light-emitting device 310 through the first opening K1.

According to some exemplary embodiments, referring to FIG. 2A and FIG. 2B, the connecting electrode 320 is located between the driving circuit layer 200 and the cover layer 600, and the connecting electrode 320 is electrically connected to the driving circuit layer 200. The connecting electrode 320 is spaced apart from an adjacent light-emitting device 310. The cover layer 600 covers at least part of a surface of the connecting electrode 320, and the cover layer 600 has a third opening K3 that exposes at least part of the connecting electrode 320. For the connecting electrode 320 and the light-emitting device 310 electrically connected thereto, one end of the first conductive sub-portion 411 is electrically connected to the connecting electrode 320 through the third opening K3, and the other end of the first conductive sub-portion 411 is electrically connected to the second electrode 313 of the light-emitting device 310 through the first opening K1.

According to some exemplary embodiments, referring to FIG. 2B, the connecting electrode 320 and the first electrode 311 are located in the same layer, that is, the connecting electrode 320 and the first electrode 311 are formed by the same thin-film deposition process and the same patterning process, which may simplify the preparation process of the display substrate.

According to some exemplary embodiments, an orthographic projection of the light-emitting device 310 on the base substrate 100 is a circle, an ellipse, a rectangle, or a rounded rectangle.

For example, referring to FIG. 2A, the orthographic projection of the light-emitting device on the base substrate 100 is a circle. FIG. 2A schematically shows the first electrode 311 and the third electrode 313 of the light-emitting device. An orthographic projection of the first electrode 311 on the base substrate 100 is a circle, and an orthographic projection of the third electrode 313 on the base substrate 100 is a circle.

FIG. 2C schematically shows an enlarged view of the display substrate in region A1 of FIG. 1 according to other embodiments of the present disclosure.

For example, referring to FIG. 2C, the orthographic projection of the light-emitting device on the base substrate 100 is a rectangle. FIG. 2C schematically shows the first electrode 311 and the third electrode 313 of the light-emitting device. The orthographic projection of the first electrode 311 on the base substrate 100 is a rectangle, and the orthographic projection of the third electrode 313 on the base substrate 100 is a rectangle. Such configuration may increase a light-emitting area of the light-emitting device 310.

FIG. 3A schematically shows an enlarged view of the display substrate in region A1 of FIG. 1 according to some embodiments of the present disclosure, in which FIG. 3A schematically shows the first electrode of the light-emitting device, the second electrode of the light-emitting device, the conductive layer, the first opening of the cover layer, and the partition portion.

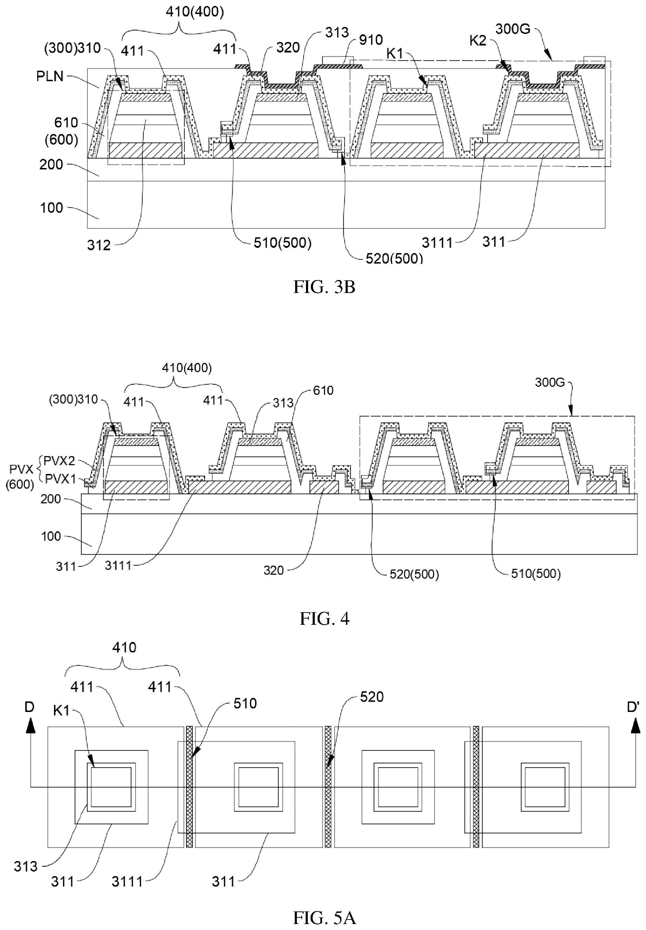

FIG. 3B schematically shows a cross-sectional view taken along line CC' in FIG. 3A.

According to some exemplary embodiments, referring to FIG. 3B, the connecting electrode 320 is located on the side of the conductive layer 400 away from the base substrate 100, the connecting electrode 320 is electrically connected to the first conductive sub-portion 411, and the orthographic projection of the connecting electrode 320 on the base substrate 100 overlaps at least partially with the orthographic projection of the light-emitting functional portion 312 on the base substrate 100. Such configuration may reduce a distance between adjacent light-emitting units 300G and further improve the resolution of the display substrate.

According to some exemplary embodiments, referring to FIG. 3B, the light-emitting device 310 may be used to emit light from the side of the second electrode 313. As the orthographic projection of the connecting electrode 320 on the base substrate 100 overlaps at least partially with the orthographic projection of the light-emitting functional portion 312 on the base substrate 100, the connecting electrode 320 may include a transparent conductive material to avoid blocking the light exit of the light-emitting device 310. For example, the material of the connecting electrode 320 may include indium tin oxide. A plurality of connecting electrodes 320 in the plurality of light-emitting units 300G may be interconnected to form a grid-like electrode structure, the grid-like electrode structure may be electrically connected to the driving circuit layer 200 in a peripheral region of the display substrate.

According to some exemplary embodiments, referring to FIG. 3B, the display substrate further includes at least one auxiliary electrode 910 electrically connected to the connecting electrode 320. An orthographic projection of the auxiliary electrode 910 on the base substrate 100 does not overlap with the orthographic projection of the light-emitting functional portion 312 on the base substrate 100. The auxiliary electrode 910 may include a metal material with high resistivity. For example, the material of the auxiliary electrode 910 may include at least one of titanium, aluminum, chromium, platinum, gold, silver, or copper. For another example, the auxiliary electrode 910 may have a stacked structure of titanium/aluminum/titanium or a stacked structure of chromium/platinum/gold. The auxiliary electrode 910 is connected in parallel with the connecting electrode 320, which reduces a voltage drop generated when the connecting electrode 320 transmits voltage signals, thereby improving a display uniformity of the display substrate.

According to some exemplary embodiments, referring toFIG. 2B, the partition portion 500 is located in the cover layer 600, that is, the partition portion 500 and the cover portion 610 are formed by the same thin-film deposition process and the same patterning process, which may simplify the preparation process of the display substrate. According to some exemplary embodiments, referring to FIG. 3A and FIG. 3B, a partition portion 500 is provided between two adjacent first conductive sub-portions 411. The partition portion 500 is connected to an adjacent cover portion 610 to form an integral structure and is spaced apart from another adjacent cover portion 610. The two adjacent first conductive sub-portions 411 are disconnected from each other at the partition portion 500. Such configuration may reduce the distance between adjacent light-emitting units 300G and further improve the resolution of the display substrate.

In embodiments of the present disclosure, the "integral structure" refers to an interconnected structure formed by two (or more) structures that are formed by the same deposition process and patterned by the same patterning process, and the two (or more) structures may be made of the same or different materials.

According to some exemplary embodiments, referring to FIG. 3A and FIG. 3B, for two adjacent and electrically connected light-emitting devices 310, a first partition portion 510 is provided between the two light-emitting devices 310. The first partition portion 510 is located on the extension portion 3111 of the first electrode 311 of one light-emitting device 310, and the partition portion 500 is connected to the cover portion 610 covering the light-emitting device 310 to form an integral structure. The extension portion 3111 protrudes towards the other light-emitting device 310 relative to the first partition portion 510, and a portion of the extension portion 3111 protruding relative to the first partition portion 510 is electrically connected to the second electrode 313 of the other light-emitting device 310 through the first conductive sub-portion 411. The two first conductive sub-portions 411 electrically connected to the two light-emitting devices 310 are disconnected from each other at the first partition portion 510.

According to some exemplary embodiments, referring to FIG. 3A and FIG. 3B, in two adjacent light-emitting units 300G, at least one light-emitting device 310 of one light-emitting unit 300G is adjacent to at least one light-emitting device 310 of the other light-emitting unit 300G, and a second partition portion 520 is provided between the two adjacent light-emitting devices 310 respectively located in two light-emitting units 300G. The second partition portion 520 is connected to the cover portion 610 covering one of the light-emitting devices 310 to form an integral structure and is spaced apart from the cover portion 610 covering the other light-emitting device 310. The two first conductive sub-portions 411 electrically connected to the two light-emitting devices 310 are disconnected from each other at the second partition portion 520. According to some exemplary embodiments, referring to FIG. 2A and FIG. 2B, two spaced partition portions 500 are provided between two adjacent first conductive sub-portions 411, and the two adjacent first conductive sub-portions 411 are disconnected from each other at a spacing position between the two partition portions 500. One of the partition portions 500 is connected to an adjacent cover portion 610 to form an integral structure, and the other partition portion 500 is spaced apart from an adjacent cover portion 610. Providing two partition portions 500 between two adjacent first conductive sub-portions 411 may further improve the partitioning effect.

FIG. 4 schematically shows a cross-sectional view of the display substrate taken along line NN' in FIG. 1 according to some embodiments of the present disclosure.

According to some exemplary embodiments, referring to FIG. 4, for two adjacent light-emitting units 300G, the connecting electrode 320 of one light-emitting unit 300G is adjacent to at least one light-emitting device 310 of the other light-emitting unit 300G. A second partition portion 520 is provided between the connecting electrode 320 and the light-emitting device 310 that are adjacent to each other and respectively located in the two light-emitting units 300G. The second partition portion 520 may be connected to the cover portion 610 covering the light-emitting device 310 to form an integral structure. The first conductive sub-portion 411 electrically connected to the connecting electrode 320 is disconnected from the first conductive sub-portion 411 electrically connected to the light-emitting device 310 at the sidewall of the second partition portion 520.

According to some exemplary embodiments, referring to FIG. 2A andFIG. 2B, in two adjacent and electrically connected light-emitting devices 310, two spaced first partition portions 510 are provided between the two light-emitting devices 310. The two first partition portions 510 are located on the extension portion 3111 of the first electrode 311 of one light-emitting device 310. One of the partition portions 500 is connected to the cover portion 610 covering the light-emitting device 310 to form an integral structure, and the other partition portion 500 is spaced apart from the cover portion 610 covering the other light-emitting device 310. The extension portion 3111 protrudes towards the other light-emitting device 310 relative to the two first partition portions 510, and a portion of the extension portion 3111 protruding relative to the two first partition portions 510 is electrically connected to the second electrode 313 of the other light-emitting device 310 through the first conductive sub-portion 411. The two first conductive sub-portions 411 electrically connected to the two light-emitting devices 310 are disconnected from each other at a spacing position between the two first partition portions 510.

According to some exemplary embodiments, referring to FIG. 2A andFIG. 2B, two spaced partition portions 500 are provided between two adjacent first conductive sub-portions 411, and the two adjacent first conductive sub-portions 411 are disconnected from each other at a spacing position between the two partition portions 500.

According to some exemplary embodiments, referring to FIG. 2A and FIG. 2B, in two adjacent light-emitting units 300G, the connecting electrode 320 of one light-emitting unit 300G is adjacent to at least one light-emitting device 310 of the other light-emitting unit 300G. Two second partition portions 520 are provided between the connecting electrode 320 and the light-emitting device 310 that are adjacent to each other and respectively located in the two light-emitting units 300G. One of the second partition portions 520 is connected to the cover portion 610 covering the connecting electrode 320 to form an integral structure, and the other second partition portion 520 is connected to the cover portion 610 covering the light-emitting device 310 to form an integral structure. The first conductive sub-portion 411 electrically connected to the connecting electrode 320 is disconnected from the first conductive sub-portion 411 electrically connected to the light-emitting device 310 at a spacing position between the two second partition portions 520.

According to some exemplary embodiments, referring toFIG. 2B the conductive portion 410 further includes a second conductive sub-portion 412 located between two spaced partition portions 500. The second conductive sub-portion 412 is disconnected from two adjacent first conductive sub-portions 411 respectively at the two partition portions 500. As the conductive layer 400 is formed through a thin-film deposition process, a partial film layer may be deposited between the two spaced partition portions 500, thus forming the second conductive sub-portion 412. However, due to the partitioning effect of the partition portions 500, the second conductive sub-portion 412 is spaced apart from the adjacent first conductive sub-portions 411, and no display defects will occur even if the second conductive sub-portion 412 is not removed by a patterning process.

FIG. 5A schematically shows an enlarged view of the display substrate in region A1 of FIG. 1 according to some embodiments of the present disclosure, in which FIG. 5A schematically shows the first electrode of the light-emitting device, the second electrode of the light-emitting device, the conductive layer, the first opening of the cover layer, and the partition portion.

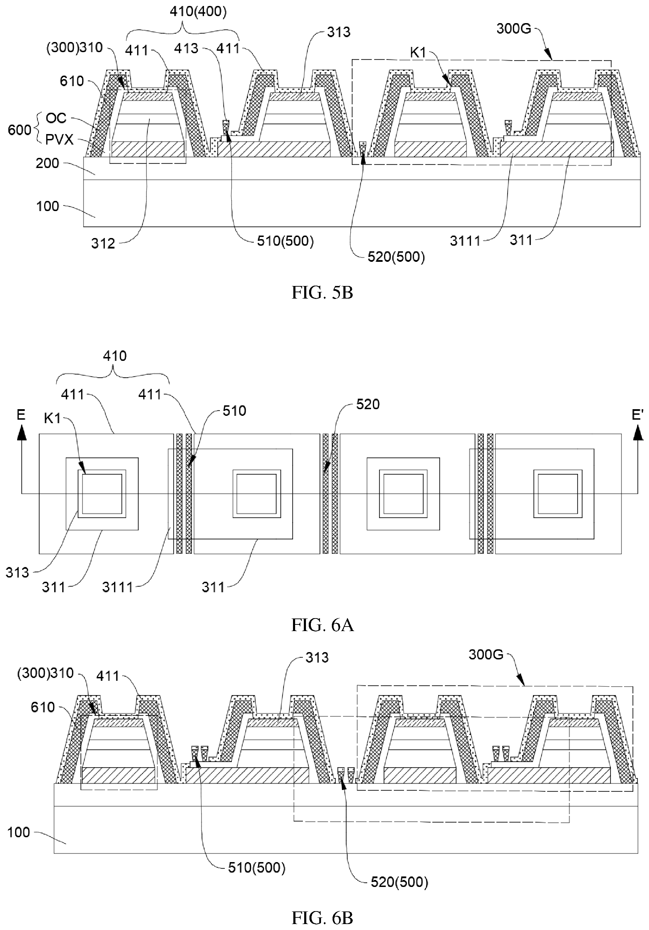

FIG. 5B schematically shows a cross-sectional view taken along line DD' in FIG. 5A.

According to some exemplary embodiments, referring to FIG. 5A and FIG. 5B, a partition portion 500 is provided between two adjacent first conductive sub-portions 411. The partition portion 500 is spaced apart from two adjacent cover portions 610, and the two adjacent first conductive sub-portions 411 are respectively located on both sides of the partition portion 500.

According to some exemplary embodiments, referring to FIG. 5A and FIG. 5B, for two adjacent and electrically connected light-emitting devices 310, a first partition portion 510 is provided between the two light-emitting devices 310, and the first partition portion 510 is spaced apart from two cover portions 610 covering the two light-emitting devices 310. The first partition portion 510 is located on the extension portion 3111 of the first electrode 311 of one light-emitting device 310. The extension portion 3111 protrudes towards the other light-emitting device 310 relative to the first partition portion 510, and a portion of the extension portion 3111 protruding relative to the first partition portion 510 is electrically connected to the second electrode 313 of the other light-emitting device 310 through the first conductive sub-portion 411. Two first conductive sub-portions 411 respectively electrically connected to the two light-emitting devices 310 are disconnected from each other at the first partition portion 510, and the two first conductive sub-portions 411 are respectively located on both sides of the first partition portion 510.

According to some exemplary embodiments, referring to FIG. 5A and FIG. 5B, for two adjacent light-emitting units 300G, at least one light-emitting device 310 of one light-emitting unit 300G is adjacent to at least one light-emitting device 310 of the other light-emitting unit 300G, a second partition portion 520 is provided between the two light-emitting devices 310 adjacent to each other and respectively located in the two light-emitting units 300G, and the second partition portion 520 is spaced apart from two covering portions 610 covering the two light-emitting devices 310. Two first conductive sub-portions 411 electrically connected to the two light-emitting devices 310 are disconnected from each other at the second partition portion 520, and the two first conductive sub-portions 411 are respectively located on both sides of the second partition portion 520.

According to some exemplary embodiments, referring to FIG. 5B, the conductive portion 410 further includes a third conductive sub-portion 413 on the side of the partition portion 500 away from the base substrate 100, and the third conductive sub-portion 413 is disconnected from two adjacent first conductive sub-portions 411 respectively at sidewalls of the partition portion 500. As the conductive layer 400 is formed through a thin-film deposition process, a partial film layer may be deposited on the side of the partition portion 500 away from the base substrate 100, thus forming the third conductive sub-portion 413. However, due to the partitioning effect of the partition portion 500, the third conductive sub-portion 413 is spaced apart from the adjacent first conductive sub-portions 411, and no display defects will occur even if the third conductive sub-portion 413 is not removed by a patterning process.

FIG. 6A schematically shows an enlarged view of the display substrate in region A1 of FIG. 1 according to some embodiments of the present disclosure, in which FIG. 6A schematically shows the first electrode of the light-emitting device, the second electrode of the light-emitting device, the conductive layer, the first opening of the cover layer, and the partition portion.

FIG. 6B schematically shows a cross-sectional view taken along line EE' in FIG. 6A.

According to some exemplary embodiments, referring to FIG. 6A and FIG. 6B, two spaced partition portions 500 are provided between two first conductive sub-portions 411 adjacent to each other, and the two adjacent first conductive sub-portions 411 are disconnected from each other at a spacing position between the two partition portions 500. One of the partition portions 500 is spaced apart from the adjacent cover portion 610, and the other partition portion 500 is spaced apart from an adjacent cover portion 610.

According to some exemplary embodiments, referring to FIG. 6A and FIG. 6B, for two light-emitting devices 310 adjacent and electrically connected to each other, two spaced first partition portions 510 are provided between the two light-emitting devices 310, and the two first partition portions 510 are located on the extension portion 3111 of the first electrode 311 of one light-emitting device 310. One of the partition portions 500 closer to the light-emitting device 310 is spaced apart from the cover portion 610 covering the light-emitting device 310, and the other partition portion 500 is spaced apart from the cover portion 610 covering the other light-emitting device 310. The extension portion 3111 protrudes towards the other light-emitting device 310 relative to the two first partition portions 510, and a portion of the extension portion 3111 protruding relative to the two first partition portions 510 is electrically connected to the second electrode 313 of the other light-emitting device 310 through the first conductive sub-portion 411. Two first conductive sub-portions 411 electrically connected to the two light-emitting devices 310 are disconnected from each other at a spacing position between the two first partition portions 510. For example, the two first conductive sub-portions 411 are respectively located on both sides of the two first partition portions 510.

According to some exemplary embodiments, referring to FIG. 6A and FIG. 6B, for two adjacent light-emitting units 300G, at least one light-emitting device 310 of one light-emitting unit 300G is adjacent to at least one light-emitting device 310 of the other light-emitting unit 300G, and two second partition portions 520 are provided between the two adjacent light-emitting devices 310 respectively located in the two light-emitting units 300G. One of the second partition portions 520 is spaced apart from the cover portion 610 covering one of the light-emitting devices 310, and the other second partition portion 520 is spaced apart from the cover portion 610 covering the other light-emitting device 310. Two first conductive sub-portions 411 electrically connected to the two light-emitting devices 310 are disconnected from each other at a spacing position between the second partition portions 520. For example, the two first conductive sub-portions 411 are respectively located on both sides of the two second partition portions 520.

According to some exemplary embodiments, referring to FIG. 2B, the cover layer 600 includes a passivation layer PVX, the passivation layer PVX includes a first passivation sub-layer PVX1 on a side of the plurality of light-emitting devices 310 away from the base substrate 100 and a second passivation sub-layer PVX2 on a side of the first passivation sub-layer PVX1 away from the base substrate 100. The partition portion 500 includes a first partition sub-portion 500a and a second partition sub-portion 500b on a side of the first partition sub-portion 500a away from the base substrate 100. The first partition sub-portion 500a is located in the first passivation sub-layer PVX1, and the second partition sub-portion 500b is located in the second passivation sub-layer PVX2. An orthographic projection of the first partition sub-portion 500a on the base substrate 100 falls within an orthographic projection of the second partition sub-portion 500b on the base substrate 100.

According to some exemplary embodiments, the first passivation sub-layer PVX1 may be made of silicon oxide, and the second passivation sub-layer PVX2 may be made of aluminum oxide. In an etching process for forming the passivation layer PVX, etching process parameters may be adjusted to make an etching rate of the first passivation sub-layer PVX1 higher than that of the second passivation sub-layer PVX2, so that an edge of the first partition sub-portion 500a is recessed relative to the second partition sub-portion 500b.

According to some exemplary embodiments, referring toFIG. 2B, in at least one partition portion 500, one side edge of the first partition sub-portion 500a is recessed relative to the second partition sub-portion 500b, and the other side edge of the first partition sub-portion 500a is substantially aligned with the edge of the second partition sub-portion 500b.

According to some exemplary embodiments, referring toFIG. 2B for two adjacent first partition portions 510, in the first partition portion 510 connected to the cover portion 610 to form an integral structure, an edge of the first partition sub-portion 500a on a side away from the connected cover portion 610 is recessed relative to the second partition sub-portion 500b, while in the first partition portion 510 spaced apart from the cover portion 610, an edge of the first partition sub-portion 500a on a side close to another adjacent first partition portion 510 is recessed relative to the second partition sub-portion 500b. That is, a "convex-shaped" groove is formed between two adjacent first partition portions 510.

According to some exemplary embodiments, referring to FIG. 2B, for two adjacent second partition portions 520, in either of the second partition portions 520, the edge of the first partition sub-portion 500a on the side close to the other first partition portion 510 is recessed relative to the second partition sub-portion 500b. That is, a "convex-shaped" groove is formed between the two adjacent second partition portions 520.

According to some exemplary embodiments, referring to FIG. 5B, the cover layer 600 includes a passivation layer PVX and an organic protective layer OC on a side of the passivation layer PVX away from the base substrate 100, and the partition portion 500 is located in the organic protective layer OC. The passivation layer PVX and the organic protective layer OC have a first opening K1 that exposes at least part of the second electrode 313 of the light-emitting device 310, and the first conductive sub-portion 411 is electrically connected to the second electrode 313 of the light-emitting device 310 through the first opening K1.

According to some exemplary embodiments, referring to FIG. 5B, a cross-section of the partition portion 500 along a direction perpendicular to the base substrate 100 is in a shape of an inverted trapezoid.

According to some exemplary embodiments, referring to FIG. 5B, for two adjacent and electrically connected light-emitting devices 310, the passivation layer PVX on one light-emitting device 310 extends from a side surface of the light-emitting functional portion 312 to the extension portion 3111 of the first electrode 311, and the passivation layer PVX covers a part of the extension portion 3111. The first partition portion 510 is located on a side of the passivation layer PVX away from the base substrate 100. A part of the extension portion 3111 not covered by the passivation layer PVX is electrically connected to the second electrode 313 of the other light-emitting device 310 through the first conductive sub-portion 411.

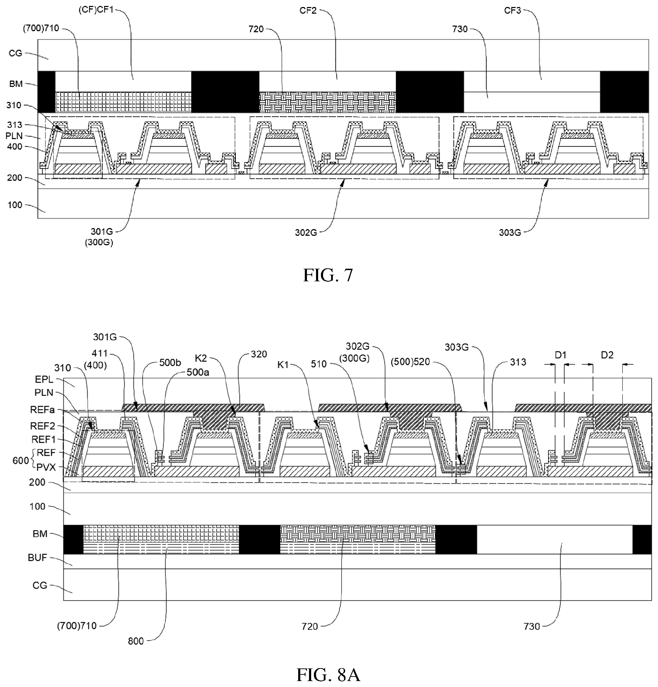

FIG. 7 schematically shows a cross-sectional view of the display substrate taken along line MM' in FIG. 1 according to some embodiments of the present disclosure.

According to some exemplary embodiments, referring to FIG. 7, at least one light-emitting unit 300G includes a first light-emitting unit 301G, a second light-emitting unit 302G and a third light-emitting unit 303G, and the light-emitting device 310 is used to emit third-color light towards the second electrode 313. The display substrate further includes a color conversion layer 700 on a side of the conductive layer 400 away from the base substrate 100. The color conversion layer 700 includes a first color conversion portion 710, a second color conversion portion 720, and a light-transmitting portion 730. An orthographic projection of the first color conversion portion 710 on the base substrate 100 overlaps at least partially with an orthographic projection of the first light-emitting unit 301G on the base substrate 100, and the first color conversion portion 710 is used to convert the third-color light into first-color light. An orthographic projection of the second color conversion portion 720 on the base substrate 100 overlaps at least partially with an orthographic projection of the second light-emitting unit 302G on the base substrate 100, and the second color conversion portion 720 is used to convert the third-color light into second-color light. An orthographic projection of the light-transmitting portion 730 on the base substrate 100 overlaps at least partially with an orthographic projection of the third light-emitting unit 303G on the base substrate 100, and the light-transmitting portion 730 allows the third-color light to transmit.

For example, the first color is red, the second color is green, and the third color is blue. That is, the light-emitting device 310 in the first light-emitting unit 301G serves as a part of a red sub-pixel, the light-emitting device 310 in the second light-emitting unit 302G serves as a part of a green sub-pixel, and the light-emitting device 310 in the third light-emitting unit 303G serves as a part of a blue sub-pixel, thereby achieving a color display.

For example, the first color conversion portion 710 includes a quantum dot material that emits red light when irradiated with blue light, and the second color conversion portion 720 includes a quantum dot material that emits green light when irradiated with blue light.

According to some exemplary embodiments, the light-emitting device is configured to emit third-color light towards the first electrode, and the color conversion layer is located on a side of the base substrate away from the light-emitting device layer.

According to some exemplary embodiments, referring to FIG. 7, the display substrate further includes a planarization layer PLN between the conductive layer 400 and the color conversion layer 700.

For example, the planarization layer PLN includes an organic adhesive material that may withstand high temperatures above 300 °C, and the planarization layer PLN has a thickness of 1µm to 5 µm.

According to some exemplary embodiments, referring to FIG. 7, the display substrate further includes a color filter layer CF on a side of the color conversion layer 700 away from the base substrate 100. The color filter layer CF includes a first color filter portion CF1, a second color filter portion CF2, and a third color filter portion CF3. The first color filter portion CF1 is located on a side of the first color conversion portion 710 away from the base substrate 100, the second color filter portion CF2 is located on a side of the second color conversion portion 720 away from the base substrate 100, and the third color filter portion CF3 is located on a side of the light-transmitting portion 730 away from the base substrate 100.

According to some exemplary embodiments, referring to FIG. 7, the display substrate further includes a black matrix layer BM, which fills spacing regions in the color conversion layer 700 and the color filter layer CF.

According to some exemplary embodiments, referring to FIG. 7, the display substrate further includes a protective cover CG on a side of the color filter layer CF away from the base substrate 100.

FIG. 8A schematically shows a cross-sectional view of the display substrate taken along line MM' in FIG. 1 according to some embodiments of the present disclosure.

According to some exemplary embodiments, referring to FIG. 8A, the cover layer 600 includes a reflective layer REF, the reflective layer REF includes a plurality of reflective portions REFa covering at least part of sidewalls of the plurality of light-emitting devices 310. The light-emitting device 310 may emit third-color light, and the reflective portion REFa may reflect the third-color light and transmit the first-color light and the second-color light. By providing the reflective portion REFa on the sidewall of the light-emitting device 310, a light exit efficiency of the light-emitting device 310 is effectively enhanced, a display brightness of the display substrate is improved, and a display power consumption of the display substrate is reduced.

According to some exemplary embodiments, the reflective layer REF has a distributed Bragg reflection (DBR) structure. The DBR structure is a periodic structure formed by alternately arranging two materials with different refractive indices, where each layer of the alternately arranged materials has an optical thickness of a quarter of a central reflection wavelength. Through the design of the DBR materials and structure, it is possible to achieve a selective reflection of light in a specific wavelength band. Referring to FIG. 8A, the reflective layer REF includes at least two first reflective sub-layers REF1 and at least two second reflective sub-layers REF2, which are alternately arranged along a direction away from the base substrate 100. The refractive index of the first reflective sub-layer REF1 is less than that of the second reflective sub-layer REF2.

According to some exemplary embodiments, the first reflective sub-layer REF1 includes at least one of silicon oxide, aluminum oxide, or magnesium fluoride, and the second reflective sub-layer REF2 includes at least one of niobium oxide, titanium dioxide, trititanium pentoxide, or silicon nitride. For example, the first reflective sub-layer REF1 includes silicon oxide, and the second reflective sub-layer REF2 includes niobium oxide. It is also possible to select other low-refractive-index materials and high-refractive-index materials according to the wavelength band of light to be reflected, which is not limited in embodiments of the present disclosure.

According to some exemplary embodiments, referring to FIG. 8A, the cover layer 600 further includes a passivation layer PVX between the reflective layer REF and the light-emitting device 310. The passivation layer PVX and the reflective layer REF have a first opening K1 that exposes at least part of the second electrode 313 of the light-emitting device 310, and the first conductive sub-portion 411 is electrically connected to the second electrode 313 of the light-emitting device 310 through the first opening K1.

According to some exemplary embodiments, the first conductive sub-portion 411 covers at least part of the sidewall of the light-emitting device 310. The first conductive sub-portion 411 includes a metal material with high reflectivity, and a composite reflective structure formed by stacking the first conductive sub-portion 411 and the reflective portion REFa has a high reflectivity, so that the light exit efficiency of the light-emitting device 310 may be further improved. For example, the first conductive sub-portion 411 has a stacked film structure of Ti/Al/Ti with thicknesses of 50/1000/100 angstroms or a stacked film structure of TiN/Al/Ti with thicknesses of 50/1000/100 angstroms.

According to some exemplary embodiments, referring to FIG. 8A, the partition portion 500 is located in the reflective layer REF. The partition portion 500 includes at least two first partition sub-portions 500a and at least two second partition sub-portions 500b, the at least two first partition sub-portions 500a are respectively located in the at least two first reflective sub-layers REF1, and the at least two second partition sub-portions 500b are respectively located in the two second reflective sub-layers REF2. For the first partition sub-portion 500a and the second partition sub-portion 500b adjacent to each other, an orthographic projection of the first partition sub-portion 500a on the base substrate 100 falls within an orthographic projection of the second partition sub-portion 500b on the base substrate 100, or the orthographic projection of the second partition sub-portion 500b on the base substrate 100 falls within the orthographic projection of the first partition sub-portion 500a on the base substrate 100.

For example, the first reflective sub-layer REF1 includes silicon oxide, and the second reflective sub-layer REF2 includes niobium oxide. In the etching process for forming the reflective layer REF, etching process parameters may be adjusted to make an etching rate of the first reflective sub-layer REF1 lower than that of the second reflective sub-layer REF2, so that an edge of the second partition sub-portion 500b is recessed relative to the first partition sub-portion 500a, that is, the orthographic projection of the second partition sub-portion 500b on the base substrate 100 falls within the orthographic projection of the first partition sub-portion 500a on the base substrate 100.

According to some exemplary embodiments, referring to FIG. 8A, for two adjacent and electrically connected light-emitting devices 310, two first partition portions 510 are provided between two first conductive sub-portions 411 respectively electrically connected to the two light-emitting devices 310, and both first partition portions 510 are located in the reflective layer REF. A maximum distance between the two first partition portions 510 is D1, and a maximum aperture size of the first opening K1 in the reflective layer REF is D2. Through research, the inventors have found that when a size difference between D1 and D2 is large, such as D1 ≤ 1/2*D2, it is possible to make the sidewall of the formed first partition portion 510 have an undercut structure and make the reflective portion REFa have a smooth sidewall structure at the first opening K1 through a single etching process by adjusting the etching process parameters.

It should be noted that for the first partition portions 510, when the edge of the second partition sub-portion 500b is recessed relative to the first partition sub-portion 500a, the maximum distance D1 between the two first partition portions 510 is a distance between the two second partition sub-portions 500b in the same second reflective sub-layer REF2; and when the edge of the first partition sub-portion 500a is recessed relative to the second partition sub-portion 500b, the maximum distance D1 between the two first partition portions 510 is a distance between the two first partition sub-portions 500a in the same first reflective sub-layer REF1. A cross-sectional shape of the first opening K1 in the reflective layer REF is approximately an inverted trapezoid, and the maximum aperture size D2 of the first opening K1 in the reflective layer REF is an aperture size of the first opening K1 on the side away from the base substrate 100.

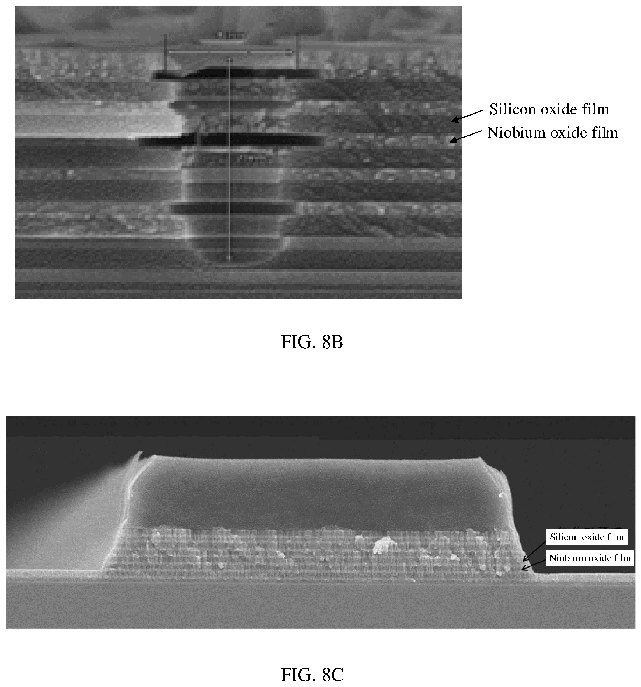

FIG. 8B shows a cross-sectional view of alternately arranged silicon oxide films and niobium oxide films after etching at the first opening, characterized by a scanning electron microscope. FIG. 8C shows a cross-sectional view of alternately arranged silicon oxide films and niobium oxide films after etching at the second opening, characterized by a scanning electron microscope.

To achieve a simultaneous formation of a partition portion with an undercut structure and an opening without an undercut structure in a single etching process, the inventors conducted the following experimental verification.

Silicon oxide films and niobium oxide films were alternately deposited on a glass substrate, and a photoresist layer was formed on the film layer by a photolithography process. The photoresist layer had a first opening with an aperture size of 0.4 µm and a second opening with an aperture size of 10 µm. Finally, under the shielding of the photoresist layer, a dry etching process was performed on the underlying film layer.

The etched substrate was structurally characterized by a scanning electron microscope. A cross-sectional morphology of the film layer after etching at the first opening is shown in FIG. 8B, where an edge of the niobium oxide film is significantly recessed relative to an edge of the silicon oxide film, forming an undercut structure; a cross-sectional morphology of the film layer after etching at the second opening is shown in FIG. 8C, where the edge of the niobium oxide film is smoothly connected to the silicon oxide film without forming an undercut structure.

According to some exemplary embodiments, referring to FIG. 8A, in two adjacent light-emitting units 300G, at least one light-emitting device 310 of one light-emitting unit 300G is adjacent to at least one light-emitting device 310 of the other light-emitting unit 300G. Two second partition portions 520 are provided between the two adjacent light-emitting devices 310 respectively located in the two light-emitting units 300G, and the maximum distance between the two second partition portions 520 is substantially equal to the maximum distance between the two first partition portions 510.

According to some exemplary embodiments, referring to FIG. 8A, the display substrate further includes a planarization layer PLN on a side of the conductive layer 400 away from the reflective layer REF. The planarization layer PLN has a second opening K2 that exposes at least part of the first conductive sub-portion 411 electrically connected to the second electrode 313 of the light-emitting device 310. The connecting electrode 320 is located on a side of the planarization layer PLN away from the base substrate 100, and the connecting electrode 320 is electrically connected to the first conductive sub-portion 411 through the second opening K2.

According to some exemplary embodiments, the connecting electrode 320 includes a metal material with low resistivity. For example, the connecting electrode 320 may be made of at least one of molybdenum, copper, or aluminum.

According to some exemplary embodiments, referring to FIG. 8A, the display substrate further includes an encapsulation layer EPL on a side of the connecting electrode 320 away from the base substrate 100. The encapsulation layer EPL may include at least one inorganic film layer made of at least one of SiO, SiN or SiCN. For example, the encapsulation layer EPL has a stacked film structure of SiO/SiN/SiCN.

According to some exemplary embodiments, referring to FIG. 8A, at least one light-emitting unit 300G includes a first light-emitting unit 301G, a second light-emitting unit 302G and a third light-emitting unit 303G, and the light-emitting device 310 is configured to emit third-color light towards the first electrode 311. The display substrate further includes a color conversion layer 700 on a side of the base substrate 100 away from the light-emitting device layer 300. The color conversion layer 700 includes a first color conversion portion 710, a second color conversion portion 720 and a light-transmitting portion 730. An orthographic projection of the first color conversion portion 710 on the base substrate 100 overlaps at least partially with an orthographic projection of the first light-emitting unit 301G on the base substrate 100, and the first color conversion portion 710 is configured to convert the third-color light into first-color light. An orthographic projection of the second color conversion portion 720 on the base substrate 100 overlaps at least partially with an orthographic projection of the second light-emitting unit 302G on the base substrate 100, and the second color conversion portion 720 is configured to convert the third-color light into second-color light. An orthographic projection of the light-transmitting portion 730 on the base substrate 100 overlaps at least partially with an orthographic projection of the third light-emitting unit 303G on the base substrate 100, and the light-transmitting portion 730 allows the third-color light to transmit.

For example, the first color is red, the second color is green, and the third color is blue. That is, the light-emitting device 310 in the first light-emitting unit 301G serves as a part of a red sub-pixel, the light-emitting device 310 in the second light-emitting unit 302G serves as a part of a green sub-pixel, and the light-emitting device 310 in the third light-emitting unit 303G serves as a part of a blue sub-pixel, thereby achieving a color display.

According to some exemplary embodiments, referring to FIG. 8A, the display substrate further includes a black matrix layer BM, which fills spacing regions in the color conversion layer 700.

According to some exemplary embodiments, referring to FIG. 8, the display substrate further includes a semi-transparent semi-reflective layer 800 on a side of the color conversion layer 700 away from the base substrate 100. The semi-transparent semi-reflective layer 800 is configured to transmit the first-color light and the second-color light and reflect the third-color light. An orthographic projection of the semi-transparent semi-reflective layer 800 on the base substrate 100 overlaps at least partially with the orthographic projection of the first color conversion portion 710 on the base substrate 100. The semi-transparent semi-reflective layer 800 may reflect the third-color light possibly contained in the light emitted by the first light-emitting unit 301G, and allow the first-color light converted by the first color conversion portion 710 to exit, thereby improving a color purity of the light emitted by the first light-emitting unit 301G.

According to some exemplary embodiments, referring to FIG. 8, the orthographic projection of the semi-transparent semi-reflective layer 800 on the base substrate 100 overlaps at least partially with the orthographic projection of the second color conversion portion 720 on the base substrate 100. The semi-transparent semi-reflective layer 800 may reflect the third-color light possibly contained in the light emitted by the second light-emitting unit 302G, and allow the second-color light converted by the second color conversion portion 720 to exit, thereby improving the color purity of the light emitted by the second light-emitting unit 302G.

According to some exemplary embodiments, referring to FIG. 8, the orthographic projection of the semi-transparent semi-reflective layer 800 on the base substrate 100 covers the orthographic projection of the first color conversion portion 710 on the base substrate 100, the orthographic projection of the semi-transparent semi-reflective layer 800 on the base substrate 100 covers the orthographic projection of the second color conversion portion 720 on the base substrate 100, and the orthographic projection of the semi-transparent semi-reflective layer 800 on the base substrate 100 does not overlap with the orthographic projection of the light-transmitting portion 730 on the base substrate 100.

According to some exemplary embodiments, the semi-transparent semi-reflective layer 800 may have a distributed Bragg reflection structure, that is, the structure of the semi-transparent semi-reflective layer 800 is similar to that of the reflective layer REF, and both are periodic structures formed by alternately arranging two materials with different refractive indices. Through the design of the materials and structure of the semi-transparent semi-reflective layer 800, it is possible to achieve a selective reflection of the third-color light.

According to some exemplary embodiments, referring to FIG. 8, a surface of the semi-transparent semi-reflective layer 800 away from the base substrate 100 is substantially aligned with a surface of the light-transmitting portion 730 away from the base substrate 100.

According to some exemplary embodiments, referring to FIG. 8, a buffer layer BUF and a protective cover CG are further provided on the side of the semi-transparent semi-reflective layer 800 away from the base substrate 100.

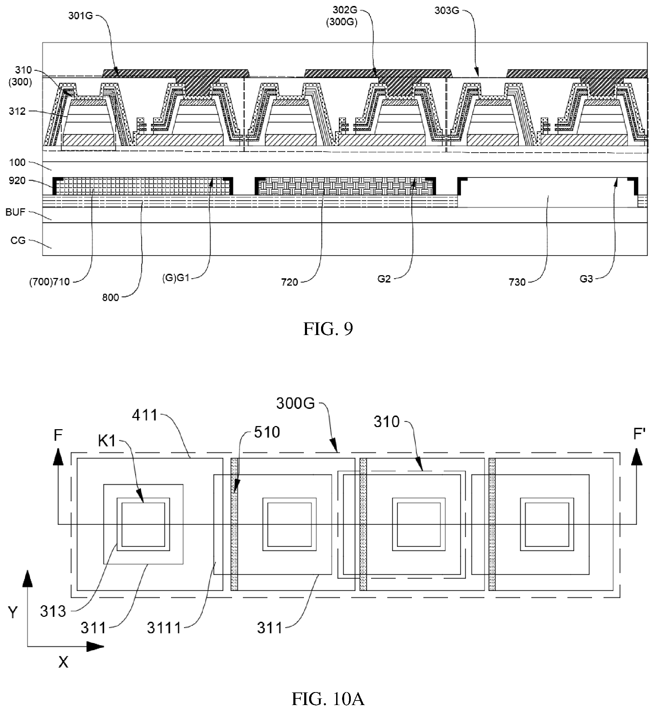

FIG. 9 schematically shows a cross-sectional view of the display substrate taken along line MM' in FIG. 1 according to some embodiments of the present disclosure.

According to some exemplary embodiments, referring to FIG. 9, a plurality of grooves G are provided on the side of the base substrate 100 away from the light-emitting device layer 300. The plurality of grooves G include a first groove G1, and at least part of the first color conversion portion 710 is embedded in the first groove G1. Such configuration may reduce a distance between the light-emitting device 310 of the first light-emitting unit 301G and the first color conversion portion 710, thereby alleviating the problem of color crosstalk between the light-emitting device 310 of the first light-emitting unit 301G and the light-emitting device 310 of the adjacent second light-emitting unit 302G or third light-emitting unit 303G.

According to some exemplary embodiments, referring to FIG. 9, a depth of the first groove G1 along the direction perpendicular to the base substrate 100 is substantially equal to a thickness of the first color conversion portion 710 along the direction perpendicular to the base substrate 100, and a surface of the first color conversion portion 710 is substantially aligned with a surface of the base substrate 100.

According to some exemplary embodiments, referring to FIG. 9, the plurality of grooves G include a second groove G2, and at least part of the second color conversion portion 720 is embedded in the second groove G2. Such configuration may reduce a distance between the light-emitting device 310 of the second light-emitting unit 302G and the second color conversion portion 720, thereby alleviating the problem of color crosstalk between the light-emitting device 310 of the second light-emitting unit 302G and the light-emitting device 310 of the adjacent first light-emitting unit 301G or third light-emitting unit 303G.

According to some exemplary embodiments, referring to FIG. 9, a depth of the second groove G2 along the direction perpendicular to the base substrate 100 is substantially equal to a thickness of the second color conversion portion 720 along the direction perpendicular to the base substrate 100, and a surface of the second color conversion portion 720 is substantially aligned with the surface of the base substrate 100.

According to some exemplary embodiments, referring to FIG. 9, the plurality of grooves G include a third groove G3, and at least part of the light-transmitting portion 730 is embedded in the third groove G3.

According to some exemplary embodiments, referring to FIG. 9, at least part of the groove G is provided with a metal reflective portion 920, the metal reflective portion 920 is located between the base substrate 100 and the color conversion layer 700. The metal reflective portion 920 covers at least part of a sidewall of the groove G, and the metal reflective portion 920 may reflect and recover the light emitted to a region of the adjacent light-emitting unit 300G, thereby further alleviating the problem of color crosstalk between adjacent light-emitting units 300G.

According to some exemplary embodiments, referring to FIG. 9, the metal reflective portion 920 extends from the sidewall of the groove G to a bottom surface of the groove G, and an orthographic projection of the metal reflective portion 920 on the base substrate 100 does not overlap with the orthographic projection of the light-emitting functional portion 312 on the base substrate 100.

According to some exemplary embodiments, the first groove G1, the second groove G2 and the third groove G3 are all provided with the metal reflective portion 920.

According to some exemplary embodiments, the metal reflective portion 920 includes silver.

According to some exemplary embodiments, referring to FIG. 9, the display substrate further includes a semi-transparent semi-reflective layer 800 on a side of the color conversion layer 700 away from the base substrate 100. The semi-transparent semi-reflective layer 800 may transmit the first-color light and the second-color light and reflect the third-color light. An orthographic projection of the semi-transparent semi-reflective layer 800 on the base substrate 100 overlaps at least partially with the orthographic projection of the first color conversion portion 710 on the base substrate 100. The semi-transparent semi-reflective layer 800 may reflect the third-color light possibly contained in the light emitted by the first light-emitting unit 301G, and allow the first-color light converted by the first color conversion portion 710 to exit, thereby improving the color purity of the light emitted by the first light-emitting unit 301G.

According to some exemplary embodiments, referring to FIG. 9, the orthographic projection of the semi-transparent semi-reflective layer 800 on the base substrate 100 overlaps at least partially with the orthographic projection of the second color conversion portion 720 on the base substrate 100. The semi-transparent semi-reflective layer 800 may reflect the third-color light possibly contained in the light emitted by the second light-emitting unit 302G, and allow the second-color light converted by the second color conversion portion 720 to exit, thereby improving the color purity of the light emitted by the second light-emitting unit 302G.

According to some exemplary embodiments, referring to FIG. 9, the orthographic projection of the semi-transparent semi-reflective layer 800 on the base substrate 100 covers the orthographic projection of the first color conversion portion 710 on the base substrate 100, the orthographic projection of the semi-transparent semi-reflective layer 800 on the base substrate 100 covers the orthographic projection of the second color conversion portion 720 on the base substrate 100, and the orthographic projection of the semi-transparent semi-reflective layer 800 on the base substrate 100 does not overlap with the orthographic projection of the light-transmitting portion 730 on the base substrate 100.

According to some exemplary embodiments, the semi-transparent semi-reflective layer 800 may have a distributed Bragg reflection structure, that is, the structure of the semi-transparent semi-reflective layer 800 is similar to that of the reflective layer REF, and both are periodic structures formed by alternately arranging two materials with different refractive indices. Through the design of the materials and structure of the semi-transparent semi-reflective layer 800, it is possible to achieve a selective reflection of the third-color light.

According to some exemplary embodiments, referring to FIG. 9, a surface of the semi-transparent semi-reflective layer 800 away from the base substrate 100 is substantially aligned with a surface of the light-transmitting portion 730 away from the base substrate 100.

According to some exemplary embodiments, referring to FIG. 9, a buffer layer BUF and a protective cover CG are further provided on the side of the semi-transparent semi-reflective layer 800 away from the base substrate 100.

FIG. 10A schematically shows an enlarged view of the display substrate in region A1 of FIG. 1 according to some embodiments of the present disclosure, in which FIG. 10A schematically shows the first electrode of the light-emitting device, the second electrode of the light-emitting device, the first opening of the cover layer, the first conductive sub-portion, and the first partition portion.

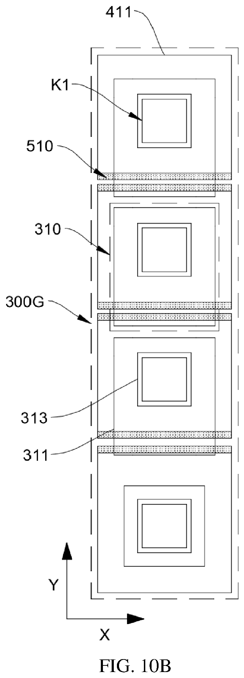

FIG. 10B schematically shows an enlarged view of the display substrate in region A2 of FIG. 1 according to some embodiments of the present disclosure, in which FIG. 10B schematically shows the first electrode of the light-emitting device, the second electrode of the light-emitting device, the first opening of the cover layer, the first conductive sub-portion, and the first partition portion.

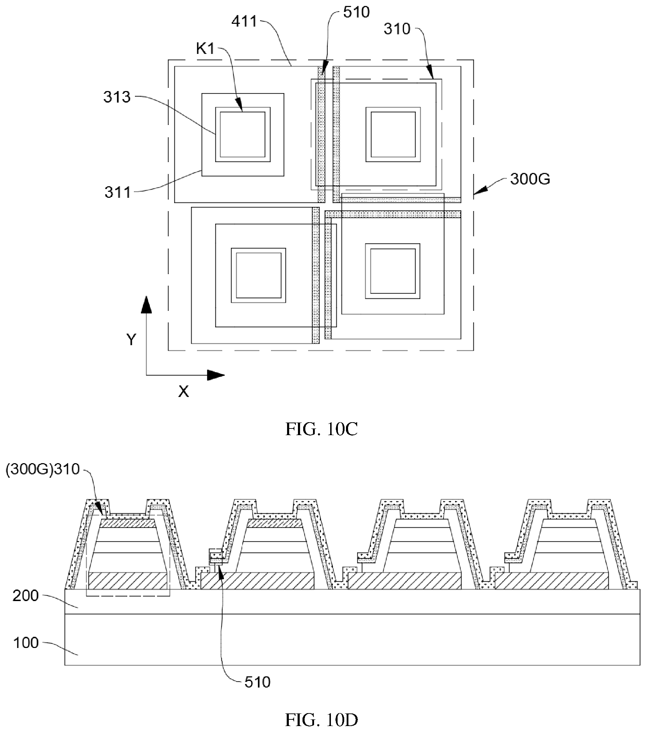

FIG. 10C schematically shows an enlarged view of the display substrate in region A3 of FIG. 1 according to some embodiments of the present disclosure, in which FIG. 10C schematically shows the first electrode of the light-emitting device, the second electrode of the light-emitting device, the first opening of the cover layer, the first conductive sub-portion, and the first partition portion.

FIG. 10D schematically shows a cross-sectional view taken along line FF' in FIG. 10A.

According to some exemplary embodiments, in at least one light-emitting unit 300G, at least two light-emitting devices 310 are arranged along the first direction X, and the first partition portion 510 extends along the second direction Y. Referring to FIG. 10A and FIG. 10D, the light-emitting unit 300G includes four light-emitting devices 310 arranged along the first direction X and sequentially connected in series, and the first partition portion 510 extends along the second direction Y.

According to some exemplary embodiments, in at least one light-emitting unit 300G, at least two light-emitting devices 310 are arranged along the second direction Y, and the first partition portion 510 extends along the first direction X. Referring to FIG. 10B, the light-emitting unit 300G includes four light-emitting devices 310 arranged along the second direction Y and sequentially connected in series, and the first partition portion 510 extends along the first direction X.

According to some exemplary embodiments, in at least one light-emitting unit 300G, at least two light-emitting devices 310 are arranged along the first direction X and at least two light-emitting devices 310 are arranged along the second direction Y, where between two light-emitting devices 310 adjacent in the first direction X, the first partition portion 510 extends along the second direction Y; and between two light-emitting devices 310 adjacent in the second direction Y, the first partition portion 510 extends along the first direction X. Referring to FIG. 10C, the light-emitting unit 300G includes four light-emitting devices 310 arranged in two rows and two columns. The first electrode 311 of the light-emitting device 310 in a first row and a first column is electrically connected to the second electrode 313 of the light-emitting device 310 in a first row and a second column through the first conductive sub-portion 411, the first electrode 311 of the light-emitting device 310 in the first row and the second column is electrically connected to the second electrode 313 of the light-emitting device 310 in a second row and a second column through the first conductive sub-portion 411, and the first electrode 311 of the light-emitting device 310 in the second row and the second column is electrically connected to the second electrode 313 of the light-emitting device 310 in the second row and the first column through the first conductive sub-portion 411, thereby achieving series connection of the four light-emitting devices 310. Between the light-emitting device 310 in the first row and the first column and the light-emitting device 310 in the first row and the second column, the first partition portion 510 extends along the second direction Y. Between the light-emitting device 310 in the second row and the first column and the light-emitting device 310 in the second row and the second column, the first partition portion 510 extends along the second direction Y. Between the light-emitting device 310 in the first row and the second column and the light-emitting device 310 in the second row and the second column, the first partition portion 510 extends along the first direction X.

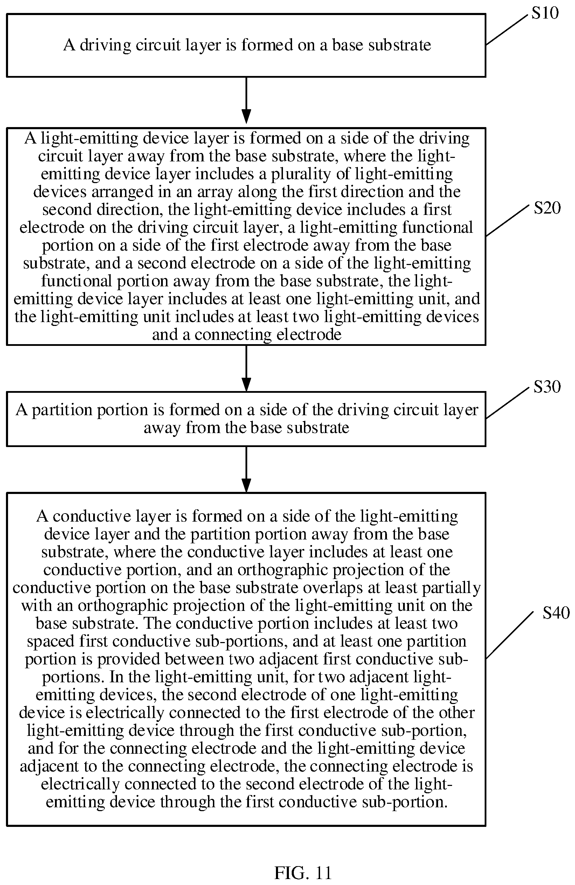

FIG. 11 schematically shows a flowchart of a method of manufacturing a display substrate according to embodiments of the present disclosure.

According to some exemplary embodiments, the method of manufacturing the display substrate includes step S10 to step S40.

In step S10, a driving circuit layer is formed on a base substrate.

In step S20, a light-emitting device layer is formed on a side of the driving circuit layer away from the base substrate. The light-emitting device layer includes a plurality of light-emitting devices arranged in an array along the first direction and the second direction. The light-emitting device includes a first electrode on the driving circuit layer, a light-emitting functional portion on a side of the first electrode away from the base substrate, and a second electrode on a side of the light-emitting functional portion away from the base substrate. The light-emitting device layer includes at least one light-emitting unit, and the light-emitting unit includes at least two light-emitting devices and a connecting electrode.

In step S30, a partition portion is formed on a side of the driving circuit layer away from the base substrate.

In step S40, a conductive layer is formed on a side of the light-emitting device layer and the partition portion away from the base substrate. The conductive layer includes at least one conductive portion, and an orthographic projection of the conductive portion on the base substrate overlaps at least partially with an orthographic projection of the light-emitting unit on the base substrate. The conductive portion includes at least two spaced first conductive sub-portions, and at least one partition portion is provided between two adjacent first conductive sub-portions. In the light-emitting unit, for two adjacent light-emitting devices, the second electrode of one light-emitting device is electrically connected to the first electrode of the other light-emitting device through the first conductive sub-portion, and for the connecting electrode and the light-emitting device adjacent to the connecting electrode, the connecting electrode is electrically connected to the second electrode of the light-emitting device through the first conductive sub-portion.

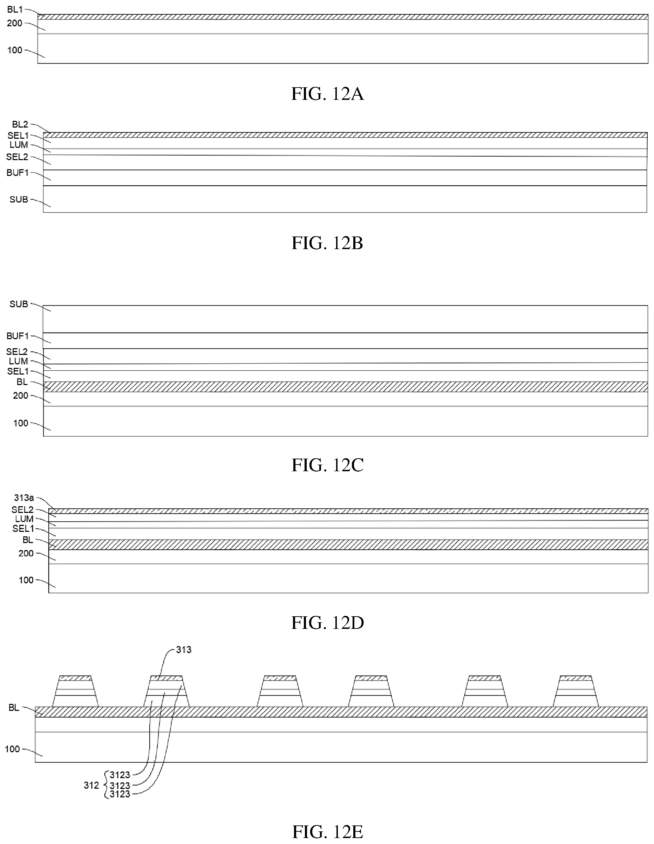

FIG. 12A to FIG. 12I schematically show process diagrams of forming the display substrate according to some embodiments of the present disclosure.

Referring to FIG. 12A, a driving circuit layer 200 is formed on a base substrate 100, and a first bonding layer BL1 is formed on a side of the driving circuit layer 200 away from the base substrate 100, thus obtaining a driver backplane.

For example, the first bonding layer BL1 may be formed by a physical vapor deposition process, and the first bonding layer BL1 includes a stacked film layer of titanium/aluminum/titanium/indium tin oxide.

Referring to FIG. 12B, a light-emitting diode epitaxial wafer is provided, which includes an epitaxial substrate SUB, a first buffer layer BUF1 on the epitaxial substrate SUB, a second semiconductor layer SEL2 on a side of the first buffer layer BUF1 away from the epitaxial substrate SUB, a light-emitting layer LUM on a side of the second semiconductor layer SEL2 away from the epitaxial substrate SUB, and a first semiconductor layer SEL1 on a side of the light-emitting layer LUM away from the epitaxial substrate SUB. A second bonding layer BL2 is formed on a side of the first semiconductor layer SEL1 away from the epitaxial substrate SUB.

For example, the epitaxial substrate SUB may be a silicon-based substrate or a sapphire substrate, the second semiconductor layer SEL2 includes N-type gallium nitride, the light-emitting layer LUM includes a multiple quantum well, and the second semiconductor layer SEL2 includes P-type gallium nitride.

For example, the second bonding layer BL2 may be an indium tin oxide film layer, an indium zinc oxide film layer, or a stacked film layer of tin/platinum/gold.

Referring to FIG. 12C, the first bonding layer BL1 on the driver backplane is bonded to the second bonding layer BL2 on the light-emitting diode epitaxial wafer., and the first bonding layer BL1 and the second bonding layer BL2 are bonded as a bonding layer BL.

Referring to FIG. 12C and FIG. 12D, the epitaxial substrate SUB and the first buffer layer BUF1 are removed, the entire surface of the second semiconductor layer SEL2 is thinned, a second electrode layer 313a is formed on a side of the thinned second semiconductor layer SEL2 away from the base substrate 100, and a thermal annealing process is finally performed on the second electrode layer 313a.

For example, the epitaxial substrate SUB may be removed by a chemical-mechanical planarization (CMP) process and a wet etching process.

For example, the first buffer layer BUF1 may be removed and the second semiconductor layer SEL2 may be globally thinned by a chemical-mechanical planarization process or a dry etching process.

For example, the thinned second semiconductor layer SEL2 has a thickness of 0.5 µm to 2 µm.

For example, the second electrode layer 313a is an indium tin oxide film layer, with a thickness of 0.1 µm to 0.3 µm.

Referring to FIG. 12D and FIG. 12E, the second electrode layer 313a, the second semiconductor layer SEL2, the light-emitting layer LUM and the first semiconductor layer SEL1 are patterned to form a plurality of first semiconductor portions 3121, a plurality of light-emitting portions 3122 on a side of the plurality of first semiconductor portions 3121 away from the base substrate 100, a plurality of second semiconductor portions 3123 on a side of the plurality of light-emitting portions 3122 away from the base substrate 100, and a plurality of second electrodes 313 on a side of the plurality of second semiconductor portions 3123 away from the base substrate 100. A first semiconductor portion 3121, a light-emitting portion 3122 and a second semiconductor portion 3123 connected to each other constitute a light-emitting functional portion 312.

For example, an orthographic projection of the light-emitting functional portion 312 on the base substrate 100 may be a circle, an ellipse, or a rectangle, etc. A size of the orthographic projection of the light-emitting functional portion 312 on the base substrate 100 along the first direction X or the second direction Y is in a range from 2 µm to 20 µm. A distance between two adjacent light-emitting functional portions 312 is in a range from 2 µm to20 µm. An angle between a sidewall and a bottom surface of the light-emitting portion 3122 is in a range from 60 ° to 80 °.

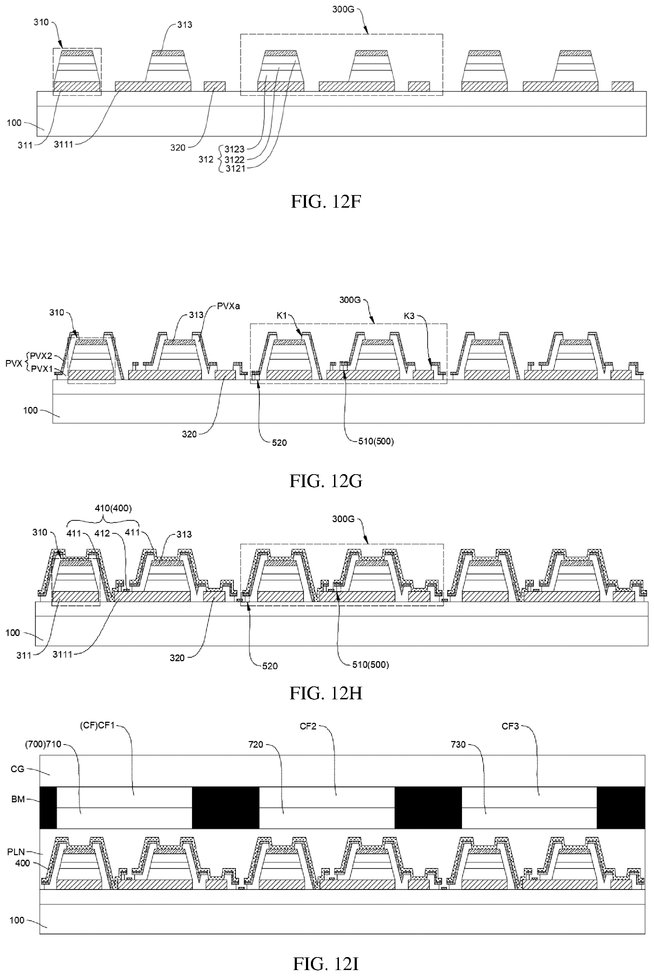

Referring to FIG. 12E and FIG. 12F, the bonding layer BL is patterned to form a plurality of first electrodes 311 and a plurality of connecting electrodes 320. The plurality of first electrodes 311 are located on a side of the plurality of first semiconductor portions 3121 close to the base substrate 100. The plurality of first electrodes 311, the plurality of light-emitting portions 3122 and the plurality of second electrodes 313 constitute a plurality of light-emitting devices 310. The plurality of light-emitting devices 310 and the plurality of connecting electrodes 320 constitute a part of a plurality of light-emitting units 300G, and the light-emitting unit 300G includes at least two light-emitting devices 310 and a connecting electrode 320. In two adjacent light-emitting devices 310 in a light-emitting unit 300G, the first electrode 311 of one light-emitting device 310 has an extension portion 3111 extending beyond an edge of the light-emitting functional portion 312, and an orthographic projection of the extension portion 3111 on the base substrate 100 does not overlap with an orthographic projection of the light-emitting functional portion 312 of the light-emitting device 310 on the base substrate 100.

Referring to FIG. 12G, a passivation layer PVX is formed on a side of the plurality of light-emitting devices 310 away from the base substrate 100. The passivation layer PVX includes a plurality of passivation portions PVXa and a plurality of partition portions 500. Some of the passivation portions PVXa cover at least part of a surface of the light-emitting device 310, and these passivation portions PVXa have a first opening K1 that exposes at least part of the second electrode 313 of the light-emitting device 310; some of the passivation portions PVXa cover at least part of the surface of the light-emitting device 310 and the surface of the adjacent connecting electrode 320, and these passivation portions PVXa have a first opening K1 and a third opening K3, where the first opening K1 exposes at least part of the second electrode 313 of the light-emitting device 310, and the third opening K3 exposes at least part of the connecting electrode 320.

The plurality of partition portions 500 include a plurality of first partition portions 510 and a plurality of second partition portions 520. For example, two first partition portions 510 are provided between two adjacent light-emitting devices 310 in the light-emitting unit 300G, and a "convex-shaped" groove is formed between the two first partition portions 510. For example, two second partition portions 520 are provided between the connecting electrode 320 of one light-emitting unit 300G and an adjacent light-emitting device 310 in another light-emitting unit 300G, and a "convex-shaped" groove is formed between the two second partition portions 520.

In some embodiments, the passivation layer PVX may be formed specifically as follows.

A first passivation material layer is formed on a side of the plurality of light-emitting devices 310 away from the base substrate 100, and a second passivation material layer is formed on a side of the first passivation material layer away from the base substrate 100.

For example, the first passivation material layer may be formed by: firstly forming a silicon oxide layer with a thickness of 500 angstroms by an atomic layer deposition process, and then forming a silicon oxide layer with a thickness of 0.3 µm to 0.6 µm by a chemical vapor deposition process.

For example, the second passivation material layer may be formed by: forming an aluminum oxide layer with a thickness of 50nm to 200 nm or a silicon nitride layer with a thickness of 50nm to 200 nm by a chemical vapor deposition process.

A patterning process and a dry etching process may be performed on the first passivation material layer and the second passivation material layer to form a passivation layer PVX. The passivation layer PVX includes a first passivation sub-layer PVX1 patterned from the first passivation material layer and a second passivation sub-layer PVX2 patterned from the second passivation material layer.

For example, two patterning processes and two dry etching processes may be performed on the first passivation material layer and the second passivation material layer. In a first patterning process and a first dry etching process, a first opening K1 and a third opening K3 are formed, and the etching process parameters are adjusted so that an edge of the first passivation sub-layer PVX1 and an edge of the second passivation sub-layer PVX2 are smoothly connected at the first opening K1 and the third opening K3. In a second patterning process and a second dry etching process, the etching process parameters are adjusted so that a "convex-shaped" groove is formed between two adjacent first partition portions 510 and a "convex-shaped" groove is formed between two adjacent second partition portions 520, that is, the edge of the second passivation sub-layer PVX2 protrudes relative to the first passivation sub-layer PVX1 at the "convex-shaped" groove.

Alternatively, it is possible to perform one patterning process and one dry etching process on the first passivation material layer and the second passivation material layer. By designing the size of the first opening K1, the size of the third opening K3, the distance between two adjacent first partition portions 510 and the distance between two adjacent second partition portions 520, it is possible to adjust the etching process parameters based on the design to form the passivation layer PVX with the above morphology in one etching process.

Referring to FIG. 12H, a conductive layer 400 is formed on a side of the plurality of partition portions 500 away from the base substrate 100. The conductive layer 400 is partitioned by the plurality of second partition portions 520 into a plurality of conductive portions 410, and the conductive portion 410 is partitioned by at least one first partition portion 510 into at least two first conductive sub-portions 411. The conductive layer 400 further includes a second conductive sub-portion 412 between two adjacent first partition portions 510 and a second conductive sub-portion 412 between two adjacent second partition portions 520. In a light-emitting unit 300G, two adjacent light-emitting devices 310 are connected in series through the first conductive sub-portion 411, that is, the extension portion 3111 of the first electrode 311 of one light-emitting device 310 is electrically connected to the second electrode 313 of the other light-emitting device 310 through the first conductive sub-portion 411, and the connecting electrode 320 is electrically connected to the second electrode 313 of the adjacent light-emitting device 310 through the first conductive sub-portion 411.

For example, the conductive layer 400 is formed by a physical vapor deposition process. The conductive layer 400 may be made of indium tin oxide, with a thickness of 0.1µm to 0.2 µm.

Referring to FIG. 12I, a planarization layer PLN is formed on a side of the conductive layer 400 away from the base substrate 100.

A protective cover CG is provided, and a black matrix layer BM with a plurality of openings is formed on the protective cover CG. A color filter layer CF is formed in the plurality of openings of the black matrix layer BM, and the color filter layer CF includes a first color filter portion CF1, a second color filter portion CF2, and a third color filter portion CF3. A color conversion layer 700 is formed on a side of the color filter layer CF away from the protective cover CG. The color conversion layer 700 includes a first color conversion portion 710, a second color conversion portion 720, and a light-transmitting portion 730. The first color conversion portion 710 is located on the first color filter portion CF1, the second color conversion portion 720 is located on the second color filter portion CF2, and the light-transmitting portion 730 is located on the third color filter portion CF3. Thus, a color filter substrate is obtained.

The color filter substrate is then aligned and bonded with the base substrate shown in FIG. 12H, followed by an encapsulation process to obtain a display substrate.

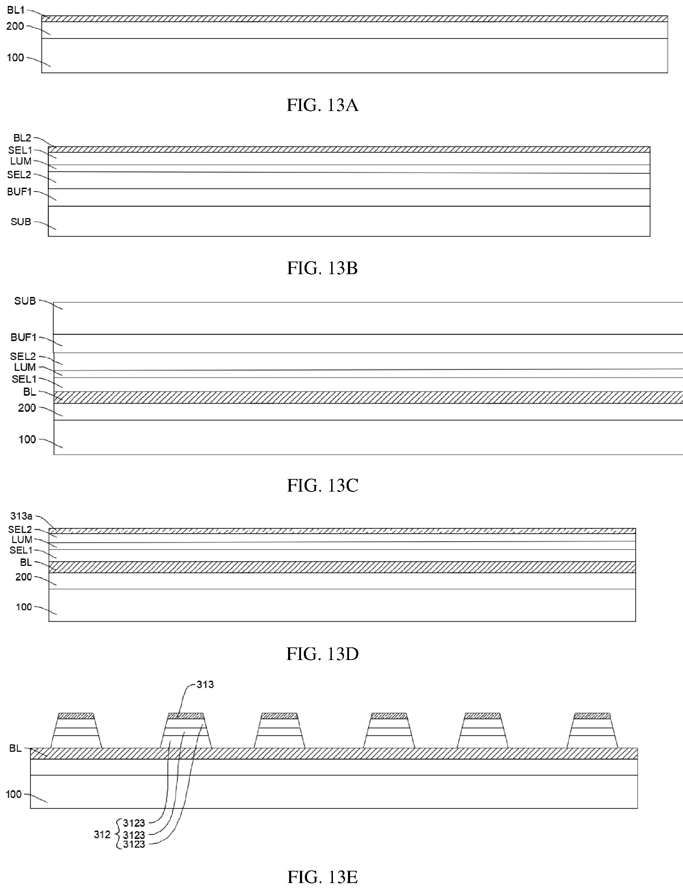

FIG. 13A to FIG. 13K schematically show process diagrams of forming the display substrate according to some embodiments of the present disclosure.

Referring to FIG. 13A, a driving circuit layer 200 is formed on a base substrate 100, and a first bonding layer BL1 is formed on a side of the driving circuit layer 200 away from the base substrate 100 to obtain a driver backplane.

For example, the first bonding layer BL1 is an indium tin oxide film layer or an indium zinc oxide film layer.

Referring to FIG. 13B, a light-emitting diode epitaxial wafer is provided, which includes an epitaxial substrate SUB, a first buffer layer BUF1 on the epitaxial substrate SUB, a second semiconductor layer SEL2 on a side of the first buffer layer BUF1 away from the epitaxial substrate SUB, a light-emitting layer LUM on a side of the second semiconductor layer SEL2 away from the epitaxial substrate SUB, and a first semiconductor layer SEL1 on a side of the light-emitting layer LUM away from the epitaxial substrate SUB. A second bonding layer BL2 is formed on a side of the first semiconductor layer SEL1 away from the epitaxial substrate SUB.

For example, the epitaxial substrate SUB may be a silicon-based substrate or a sapphire substrate, the second semiconductor layer SEL2 includes N-type gallium nitride, the light-emitting layer LUM includes a multiple quantum well, and the second semiconductor layer SEL2 includes P-type gallium nitride.

For example, the second bonding layer BL2 is an indium tin oxide film layer or an indium zinc oxide film layer.

Referring to FIG. 13C, the first bonding layer BL1 on the driver backplane is bonded to the second bonding layer BL2 on the light-emitting diode epitaxial wafer, and the first bonding layer BL1 and the second bonding layer BL2 are bonded as a bonding layer BL.

Referring to FIG. 13C and FIG. 13D, the epitaxial substrate SUB and the first buffer layer BUF1 are removed, the second semiconductor layer SEL2 is globally thinned, a second electrode layer 313a is formed on a side of the thinned second semiconductor layer SEL2 away from the base substrate 100, and a thermal annealing process is finally performed on the second electrode layer 313a.

For example, the second electrode layer 313a is an indium tin oxide film layer, with a thickness of 0.1 µm to 0.3 µm.

Referring to FIG. 13D and FIG. 13E, the second electrode layer 313a, the second semiconductor layer SEL2, the light-emitting layer LUM and the first semiconductor layer SEL1 are patterned to form a plurality of first semiconductor portions 3121, a plurality of light-emitting portions 3122 on a side of the plurality of first semiconductor portions 3121 away from the base substrate 100, a plurality of second semiconductor portions 3123 on a side of the plurality of light-emitting portions 3122 away from the base substrate 100, and a plurality of second electrodes 313 on a side of the plurality of second semiconductor portions 3123 away from the base substrate 100. A first semiconductor portion 3121, a light-emitting portion 3122 and a second semiconductor portion 3123 connected to each other constitute a light-emitting functional portion 312.

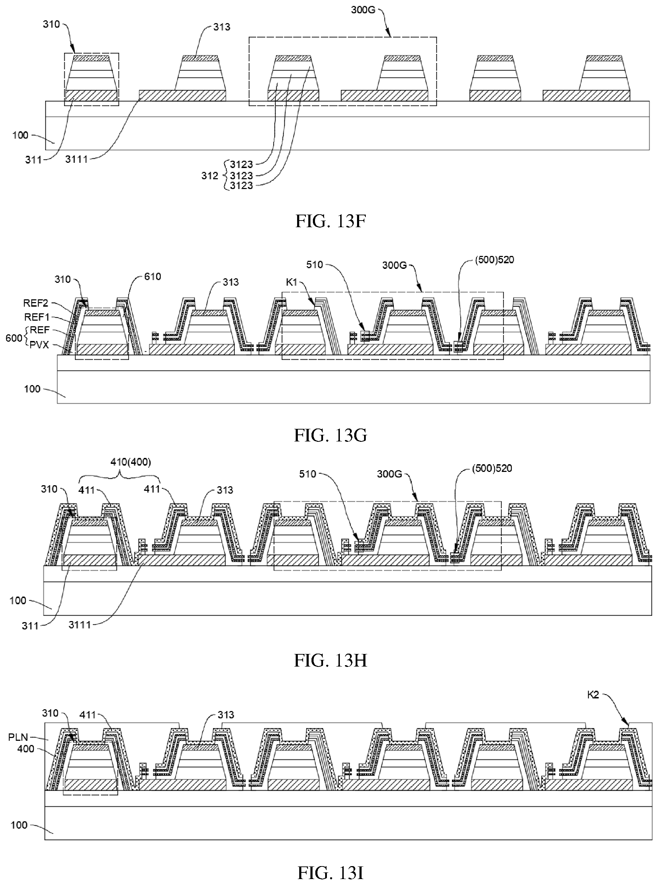

Referring to FIG. 13E and FIG. 13F, the bonding layer BL is patterned to form a plurality of first electrodes 311 on a side of the plurality of first semiconductor portions 3121 close to the base substrate 100. The plurality of first electrodes 311, the plurality of light-emitting portions 3122 and the plurality of second electrodes 313 constitute a plurality of light-emitting devices 310. The plurality of light-emitting devices 310 constitute a part of a plurality of light-emitting units 300G, and the light-emitting unit 300G includes at least two light-emitting devices 310. In two adjacent light-emitting devices 310 in a light-emitting unit 300G, the first electrode 311 of one light-emitting device 310 has an extension portion 3111 extending beyond an edge of the light-emitting functional portion 312, and an orthographic projection of the extension portion 3111 on the base substrate 100 does not overlap with an orthographic projection of the light-emitting functional portion 312 of the light-emitting device 310 on the base substrate 100.

Referring to FIG. 13G, a cover layer 600 is formed on a side of the plurality of light-emitting devices 310 away from the base substrate 100. The cover layer 600 includes a passivation layer PVX on the side of the plurality of light-emitting devices 310 away from the base substrate 100 and a reflective layer REF on a side of the passivation layer PVX away from the base substrate 100. The cover layer 600 includes a plurality of cover portions 610 and a plurality of partition portions 500, where the cover portions 610 are located in the passivation layer PVX and the reflective layer REF, and the partition portions 500 are located in the reflective layer REF. The cover portion 610 covers at least part of a surface of the light-emitting device 310, and the cover portion 610 has a first opening K1 that exposes at least part of the second electrode 313 of the light-emitting device 310.

The plurality of partition portions 500 include a plurality of first partition portions 510 and a plurality of second partition portions 520. For example, two first partition portions 510 are provided between two adjacent light-emitting devices 310 in a light-emitting unit 300G, and opposite sides of the two first partition portions 510 each have an undercut structure. For example, two second partition portions 520 are provided between a light-emitting device 310 in a light-emitting unit 300G and an adjacent light-emitting device 310 in another light-emitting unit 300G, and opposite sides of the two second partition portions 520 each have an undercut structure.

In some embodiments, the passivation layer PVX may be formed specifically as follows.

A passivation material layer is formed on the side of the plurality of light-emitting devices 310 away from the base substrate 100. At least two first reflective material layers and at least two second reflective material layers are formed on a side of the passivation material layer away from the base substrate 100, where the at least two first reflective material layers and the at least two second reflective material layers are alternately arranged along a direction away from the base substrate 100, and a refractive index of the first reflective material layer is less than that of the second reflective material layer.

For example, the passivation material layer may be formed by: firstly forming a silicon oxide layer with a thickness of 500 angstroms by an atomic layer deposition process, and then forming a silicon oxide layer with a thickness of 0.2 µm to 0.3 µm by a chemical vapor deposition process.

For example, the first reflective material layer includes at least one of silicon oxide, aluminum oxide, or magnesium fluoride, and the second reflective material layer includes at least one of niobium oxide, titanium dioxide, trititanium pentoxide, or silicon nitride.

A patterning process and a dry etching process may be performed on the passivation material layer, the at least two first reflective material layers and the at least two second reflective material layers to form a passivation layer PVX and a reflective layer REF. The reflective layer REF includes first reflective sub-layers REF1 patterned from the first reflective material layers and second reflective sub-layers REF2 patterned from the second reflective material layers.

For example, it is possible to perform one patterning process and one dry etching process on the passivation material layer, the at least two first reflective material layers and the at least two second reflective material layers. By designing the size of the first opening K1, the distance between two adjacent first partition portions 510 and the distance between two adjacent second partition portions 520, it is possible to adjust the etching process parameters based on the design so that by one etching process, an edge of the first reflective sub-layer REF1 and an edge of the second reflective sub-layer REF2 are smoothly connected at the first opening K1, and the edge of the first reflective sub-layer REF1 protrudes relative to the edge of the second reflective sub-layer REF2 or the edge of the second reflective sub-layer REF2 protrudes relative to the edge of the first reflective sub-layer REF1 at the partition portion 500.

Referring to FIG. 13H, a conductive layer 400 is formed on a side of the plurality of partition portions 500 away from the base substrate 100. The conductive layer 400 is partitioned by the plurality of second partition portions 520 into a plurality of conductive portions 410, and the conductive portion 410 is partitioned by at least one first partition portion 510 into at least two first conductive sub-portions 411. The conductive layer 400 further includes a second conductive sub-portion 412 between two adjacent first partition portions 510 and a second conductive sub-portion 412 between two adjacent second partition portions 520. In a light-emitting unit 300G, two adjacent light-emitting devices 310 are connected in series through the first conductive sub-portion 411, that is, the extension portion 3111 of the first electrode 311 of one light-emitting device 310 is electrically connected to the second electrode 313 of the other light-emitting device 310 through the first conductive sub-portion 411.

For example, the conductive layer 400 is formed by a physical vapor deposition process. The conductive layer 400 may have a stacked film structure of Ti/Al/Ti with thicknesses of 50/1000/100 angstroms or a stacked film structure of TiN/Al/Ti with thicknesses of 50/1000/100 angstroms.

Referring to FIG. 13I, a planarization layer PLN is formed on a side of the conductive layer 400 away from the base substrate 100. The planarization layer PLN has a second opening K2 that exposes at least part of the first conductive sub-portion 411 electrically connected to the second electrode 313 of the light-emitting device 310.

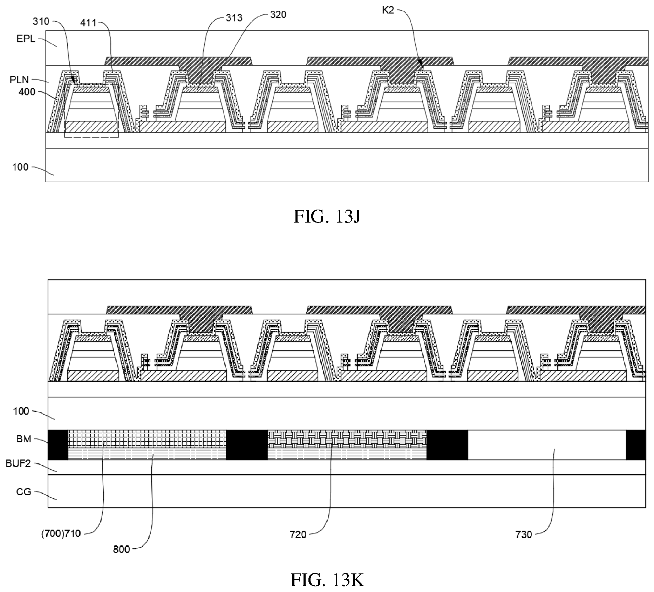

Referring to FIG. 13J, a connecting electrode 320 is formed on a side of the planarization layer PLN away from the base substrate 100, and an encapsulation layer EPL is formed on a side of the connecting electrode 320 away from the base substrate 100. The connecting electrode 320 is electrically connected to the first conductive sub-portion 411 through the second opening K2.

Referring to FIG. 13K, a protective cover CG is provided, and a second buffer layer BUF2 is formed on the protective cover CG. A black matrix layer BM with a plurality of openings is formed on a side of the second buffer layer BUF2 away from the protective cover CG. A semi-transparent semi-reflective layer 800 is formed in some of the openings of the black matrix layer BM. A color conversion layer 700 is formed on a side of the semi-transparent semi-reflective layer 800 away from the protective cover CG. The color conversion layer 700 is located in the plurality of openings of the black matrix layer BM, and includes a first color conversion portion 710, a second color conversion portion 720 and a light-transmitting portion 730, thus a color filter substrate is obtained.

The color filter substrate is then aligned and bonded with the base substrate shown in FIG. 13J, followed by an encapsulation process to obtain a display substrate.

At least some embodiments of the present disclosure further provide a display apparatus including the above display substrate. The display apparatus may include any apparatus or product having a display function. For example, the display apparatus may be a smart phone, a mobile phone, an e-book reader, a desktop personal computer (PC), a laptop PC, a netbook PC, a personal digital assistant (PDA), a portable multimedia player (PMP), a digital audio player, a mobile medical apparatus, a camera, a wearable apparatus (such as a head-mounted apparatus, electronic clothing, electronic bracelet, electronic necklace, electronic accessory, electronic tattoo, or smart watch), a television, etc.

It should be understood that the display panel and the display apparatus according to embodiments of the present disclosure have all the features and advantages of the above display substrate. The details may be referred to the above descriptions and will not be repeated here. While some embodiments of the general technical concept of the present disclosure have been shown and described, those ordinary skilled in the art may understand that changes may be made to these embodiments without departing from the principles and spirit of the general technical concept, and the scope of the present disclosure is defined by the claims and their equivalents.

## Claims

1. A display substrate, comprising:
a base substrate;
a driving circuit layer on the base substrate;
a light-emitting device layer on a side of the driving circuit layer away from the base substrate, wherein the light-emitting device layer comprises a plurality of light-emitting devices arranged in an array along a first direction and a second direction, the light-emitting device comprises a first electrode on the driving circuit layer, a light-emitting functional portion on a side of the first electrode away from the base substrate and a second electrode on a side of the light-emitting functional portion away from the base substrate, the light-emitting device layer comprises at least one light-emitting unit, the light-emitting unit comprises at least two light-emitting devices and a connecting electrode sequentially connected in series; and
a conductive layer on a side of the plurality of light-emitting devices away from the base substrate, wherein the conductive layer comprises at least one conductive portion, an orthographic projection of the conductive portion on the base substrate overlaps at least partially with an orthographic projection of the light-emitting unit on the base substrate, and the conductive portion comprises at least two first conductive sub-portions arranged at intervals;
wherein for two adjacent and electrically connected light-emitting devices in the light-emitting unit, the second electrode of one light-emitting device is electrically connected to the first electrode of the other light-emitting device through the first conductive sub-portion, and for the connecting electrode and the light-emitting device electrically connected to the connecting electrode, the connecting electrode is electrically connected to the second electrode of the light-emitting device through the first conductive sub-portion; and
wherein the display substrate further comprises a partition portion, and at least one partition portion is provided between two adjacent first conductive sub-portions.

2. The display substrate according to claim 1, wherein the partition portion comprises a first partition portion, and at least one first partition portion is provided between two adjacent first conductive sub-portions in the conductive portion; and/or
wherein the partition portion comprises a second partition portion, and at least one second partition portion is provided between two adjacent conductive portions.

3. The display substrate according to claim 2, wherein for two adjacent light-emitting devices in the light-emitting unit, the first electrode of one light-emitting device has an extension portion extending beyond an edge of the light-emitting functional portion, and the extension portion is electrically connected to the second electrode of the other light-emitting device through the first conductive sub-portion.

4. The display substrate according to claim 3, wherein at least part of the first partition portion is located on a side of the extension portion away from the base substrate, and a size of the first partition portion along an extension direction of the first partition portion is greater than or equal to a size of the extension portion along the extension direction of the first partition portion.

5. The display substrate according to any one of claims 2 to 4, wherein the partition portion has a first surface away from the base substrate and a second surface facing the base substrate, and an orthographic projection of the second surface on the base substrate falls within an orthographic projection of the first surface on the base substrate.

6. The display substrate according to any one of claims 2 to 5, wherein the display substrate further comprises a cover layer between the plurality of light-emitting devices and the conductive layer, the cover layer comprising a plurality of cover portions respectively covering at least parts of surfaces of the plurality of light-emitting devices;
wherein the cover portion comprises a first opening exposing at least part of the second electrode of the light-emitting device, and the first conductive sub-portion is electrically connected to the second electrode of the light-emitting device through the first opening; and
wherein the partition portion is located in the cover layer.

7. The display substrate according to claim 6, wherein one partition portion is provided between two adjacent first conductive sub-portions, the one partition portion is connected to an adjacent cover portion to form an integral structure and is spaced apart from another adjacent cover portion, and the two adjacent first conductive sub-portions are disconnected from each other at the one partition portion.

8. The display substrate according to claim 6, wherein two spaced partition portions are provided between two adjacent first conductive sub-portions, and the two adjacent first conductive sub-portions are disconnected from each other at a spacing position between the two partition portions;
wherein one of the two spaced partition portions is connected to an adjacent cover portion to form an integral structure, and the other of the two spaced partition portions is spaced apart from an adjacent cover portion; and/or
one of the two spaced partition portions is connected to an adjacent cover portion to form an integral structure, and the other of the two spaced partition portions is connected to an adjacent cover portion to form an integral structure; and/or
one of the two spaced partition portions is spaced apart from an adjacent cover portion, and the other of the two spaced partition portions is spaced apart from an adjacent cover portion.

9. The display substrate according to claim 8, wherein the conductive portion further comprises a second conductive sub-portion located between the two spaced partition portions, and the second conductive sub-portion is disconnected from the two adjacent first conductive sub-portions at the two spaced partition portions.

10. The display substrate according to claim 6, wherein one partition portion is provided between two adjacent first conductive sub-portions, the one partition portion is spaced apart from two cover portions adjacent to the partition portion, and the two adjacent first conductive sub-portions are respectively located on both sides of the one partition portion.

11. The display substrate according to any one of claims 6 to 10, wherein the cover layer comprises a passivation layer, the passivation layer comprises a first passivation sub-layer on a side of the plurality of light-emitting devices away from the base substrate and a second passivation sub-layer on a side of the first passivation sub-layer away from the base substrate, the partition portion comprises a first partition sub-portion and a second partition sub-portion on a side of the first partition sub-portion away from the base substrate, the first partition sub-portion is located in the first passivation sub-layer, the second partition sub-portion is located in the second passivation sub-layer, and an orthographic projection of the first partition sub-portion on the base substrate falls within an orthographic projection of the second partition sub-portion on the base substrate.

12. The display substrate according to any one of claims 6 to 10, wherein the cover layer comprises an organic protective layer, the partition portion is located in the organic protective layer, and a cross-section of the partition portion along a direction perpendicular to the base substrate is in a shape of an inverted trapezoid.

13. The display substrate according to any one of claims 1 to 12, wherein the connecting electrode is located on a side of the driving circuit layer away from the base substrate, and the connecting electrode is spaced apart from an adjacent light-emitting device.

14. The display substrate according to claim 13, wherein the connecting electrode and the first electrode are located in a same layer.

15. The display substrate according to any one of claims 6 to 10, wherein the connecting electrode is located on a side of the conductive layer away from the base substrate, the connecting electrode is electrically connected to the first conductive sub-portion, and an orthographic projection of the connecting electrode on the base substrate overlaps at least partially with an orthographic projection of the light-emitting functional portion on the base substrate.

16. The display substrate according to claim 15, wherein the display substrate further comprises at least one auxiliary electrode electrically connected to the connecting electrode, and an orthographic projection of the auxiliary electrode on the base substrate does not overlap with the orthographic projection of the light-emitting functional portion on the base substrate.

17. The display substrate according to any one of claims 1 to 16, wherein the at least one light-emitting unit comprises a first light-emitting unit, a second light-emitting unit and a third light-emitting unit, and the light-emitting device is configured to emit third-color light;
wherein the display substrate further comprises a color conversion layer on a side of the conductive layer away from the base substrate or on a side of the base substrate away from the light-emitting device layer; and
wherein the color conversion layer comprises a first color conversion portion and a second color conversion portion, an orthographic projection of the first color conversion portion on the base substrate overlaps at least partially with an orthographic projection of the first light-emitting unit on the base substrate, the first color conversion portion is configured to convert the third-color light into first-color light, an orthographic projection of the second color conversion portion on the base substrate overlaps at least partially with an orthographic projection of the second light-emitting unit on the base substrate, and the second color conversion portion is configured to convert the third-color light into second-color light.

18. The display substrate according to any one of claims 6 to 10, wherein the cover layer comprises a reflective layer, the reflective layer comprises a plurality of reflective portions covering at least part of sidewalls of the plurality of light-emitting devices, the light-emitting device is configured to emit third-color light, and the reflective portion is configured to reflect the third-color light and transmit first-color light and second-color light.

19. The display substrate according to claim 18, wherein the partition portion is located in the reflective layer.

20. The display substrate according to claim 19, wherein the reflective layer comprises at least two first reflective sub-layers and at least two second reflective sub-layers alternately arranged along a direction away from the base substrate, and a refractive index of the first reflective sub-layer is less than a refractive index of the second reflective sub-layer;
wherein the partition portion comprises at least two first partition sub-portions and at least two second partition sub-portions, the at least two first partition sub-portions are respectively located in the at least two first reflective sub-layers, and the at least two second partition sub-portions are respectively located in the two second reflective sub-layers; and
wherein for a first partition sub-portion and a second partition sub-portion adjacent to each other, an orthographic projection of the first partition sub-portion on the base substrate falls within an orthographic projection of the second partition sub-portion on the base substrate, or an orthographic projection of the second partition sub-portion on the base substrate falls within an orthographic projection of the first partition sub-portion on the base substrate.

21. The display substrate according to any one of claims 18 to 20, wherein the display substrate further comprises a planarization layer on a side of the conductive layer away from the reflective layer, the planarization layer has a second opening that exposes at least part of the first conductive sub-portion electrically connected to the second electrode of the light-emitting device; and
wherein the connecting electrode is located on a side of the planarization layer away from the base substrate, and the connecting electrode is electrically connected to the first conductive sub-portion through the second opening.

22. The display substrate according to any one of claims 18 to 21, wherein the at least one light-emitting unit comprises a first light-emitting unit, a second light-emitting unit and a third light-emitting unit, and the light-emitting device is configured to emit third-color light;
wherein the display substrate further comprises a color conversion layer on a side of the base substrate away from the light-emitting device layer; and
wherein the color conversion layer comprises a first color conversion portion, a second color conversion portion and a light-transmitting portion, an orthographic projection of the first color conversion portion on the base substrate overlaps at least partially with an orthographic projection of the first light-emitting unit on the base substrate, the first color conversion portion is configured to convert the third-color light into first-color light, an orthographic projection of the second color conversion portion on the base substrate overlaps at least partially with an orthographic projection of the second light-emitting unit on the base substrate, the second color conversion portion is configured to convert the third-color light into second-color light, an orthographic projection of the light-transmitting portion on the base substrate overlaps at least partially with an orthographic projection of the third light-emitting unit on the base substrate, and the light-transmitting portion is configured to transmit the third-color light.

23. The display substrate according to claim 22, wherein a plurality of grooves are provided on the side of the base substrate away from the light-emitting device layer, the plurality of grooves comprise a first groove, and at least part of the first color conversion portion is embedded in the first groove; and/or
the plurality of grooves comprise a second groove, and at least part of the second color conversion portion is embedded in the second groove; and/or
the plurality of grooves comprise a third groove, and at least part of the light-transmitting portion is embedded in the third groove.

24. The display substrate according to claim 23, wherein at least part of the groove is provided with a metal reflective portion, the metal reflective portion is located between the base substrate and the color conversion layer, and the metal reflective portion covers at least part of a sidewall of the groove.

25. The display substrate according to any one of claims 22 to 24, wherein the display substrate further comprises a semi-transparent semi-reflective layer on a side of the color conversion layer away from the base substrate, and the semi-transparent semi-reflective layer is configured to transmit the first-color light and the second-color light and reflect the third-color light;
wherein an orthographic projection of the semi-transparent semi-reflective layer on the base substrate overlaps at least partially with the orthographic projection of the first color conversion portion on the base substrate; and/or
wherein an orthographic projection of the semi-transparent semi-reflective layer on the base substrate overlaps at least partially with the orthographic projection of the second color conversion portion on the base substrate.

26. The display substrate according to any one of claims 1 to 25, wherein in at least one light-emitting unit, the at least two light-emitting devices are arranged along the first direction, and the first partition portion extends along the second direction; and/or
in at least one light-emitting unit, the at least two light-emitting devices are arranged along the second direction, and the first partition portion extends along the first direction.

27. The display substrate according to any one of claims 1 to 25, wherein in at least one light-emitting unit, at least two light-emitting devices are arranged along the first direction and at least two light-emitting devices are arranged along the second direction;
wherein between two light-emitting devices adjacent in the first direction, the first partition portion extends along the second direction; and/or
wherein between two light-emitting devices adjacent in the second direction, the first partition portion extends along the first direction.

28. The display substrate according to any one of claims 1 to 27, wherein an orthographic projection of the light-emitting device on the base substrate is in a shape of a circle, an ellipse, a rectangle, or a rounded rectangle.

29. A method of manufacturing a display substrate, comprising:
forming a driving circuit layer on a base substrate;
forming a light-emitting device layer on a side of the driving circuit layer away from the base substrate, wherein the light-emitting device layer comprises a plurality of light-emitting devices arranged in an array along a first direction and a second direction, the light-emitting device comprises a first electrode on the driving circuit layer, a light-emitting functional portion on a side of the first electrode away from the base substrate and a second electrode on a side of the light-emitting functional portion away from the base substrate, the light-emitting device layer comprises at least one light-emitting unit, and the light-emitting unit comprises at least two light-emitting devices and a connecting electrode;
forming a partition portion on a side of the driving circuit layer away from the base substrate; and
forming a conductive layer on a side of the light-emitting device layer and the partition portion away from the base substrate, wherein the conductive layer comprises at least one conductive portion, an orthographic projection of the conductive portion on the base substrate overlaps at least partially with an orthographic projection of the light-emitting unit on the base substrate, the conductive portion comprises at least two first conductive sub-portions arranged at intervals, at least one partition portion is provided between two adjacent first conductive sub-portions, wherein in the light-emitting unit, for two adjacent light-emitting devices, the second electrode of one light-emitting device is electrically connected to the first electrode of the other light-emitting device through the first conductive sub-portion, and for the connecting electrode and the light-emitting device adjacent to the connecting electrode, the connecting electrode is electrically connected to the second electrode of the light-emitting device through the first conductive sub-portion.

30. A display apparatus, comprising the display substrate according to any one of claims 1 to 28.
